(19) Europäisches Patentamt
European Patent Office
Office européen des brevets

(11) EP 2 320 490 B1

(12) **EUROPEAN PATENT SPECIFICATION**

(45) Date of publication and mention of the grant of the patent:
**03.04.2019 Bulletin 2019/14**

(51) Int Cl.:
***H01L 51/52*** *(2006.01)*

(21) Application number: **10190317.7**

(22) Date of filing: **08.11.2010**

(54) **Organic electroluminescent device**

Organische elektrolumineszente Vorrichtung

Dispositif électroluminescent organique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.11.2009 JP 2009256328**

(43) Date of publication of application:
**11.05.2011 Bulletin 2011/19**

(73) Proprietor: **UDC Ireland Limited**
**Ballycoolin, Dublin 15 (IE)**

(72) Inventors:
- **Kinoshita, Masaru**
  **Kanagawa (JP)**
- **Hayashi, Masayuki**
  **Kanagawa (JP)**

(74) Representative: **Maiwald Patent- und Rechtsanwaltsgesellschaft mbH**
**Elisenhof**
**Elisenstraße 3**
**80335 München (DE)**

(56) References cited:
**JP-A- 2007 043 130**
**US-A1- 2003 099 865**
**US-A1- 2006 273 714**

- **MATSUSHIMA TOSHINORI ET AL: "Enhancing power conversion efficiencies and operational stability of organic light-emitting diodes by increasing carrier injection efficiencies at anode/organic and organic/organic heterojunction interfaces", JOURNAL OF APPLIED PHYSICS, AMERICAN INSTITUTE OF PHYSICS. NEW YORK, US, vol. 104, no. 3, 6 August 2008 (2008-08-06), pages 34507-34507, XP012117192, ISSN: 0021-8979, DOI: 10.1063/1.2964113**
- **AZIZ H ET AL: "DEGRADATION MECHANISM OF SMALL MOLECULE-BASED ORGANIC LIGHT-EMITTING DEVICES", SCIENCE, AMERICAN ASSOCIATION FOR THE ADVANCEMENT OF SCIENCE, WASHINGTON, DC; US, vol. 283, 1 March 1999 (1999-03-01), pages 1900-1902, XP002934450, ISSN: 0036-8075, DOI: 10.1126/SCIENCE.283.5409.1900**
- **MIKHAIL A. PARSHIN ET AL: "Charge carrier mobility in CBP films doped with Ir(ppy)3", PROCEEDINGS OF SPIE, vol. 6192, 20 April 2006 (2006-04-20), pages 61922A-61922A-8, XP055204062, ISSN: 0277-786X, DOI: 10.1117/12.663553**
- **Sang-Bong Lee ET AL: "CHARGE CARRIER MOBILITY IN VACUUM-SUBLIMED DYE FILMS FOR LIGHT-EMITTING DIODES STUDIED BY THE TIME-OF-FLIGHT TECHNIQUE", Molecular Crystals and Liquid Crystals, vol. 405, no. 1, 1 January 2003 (2003-01-01), pages 67-73, XP055204095, ISSN: 1542-1406, DOI: 10.1080/15421400390264162**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 320 490 B1

## Description

BACKGROUND OF THE INVENTION

Field of the Invention

The present invention relates to an organic electroluminescent device (hereinafter, appropriately briefly referred to as "organic EL device"), and more particularly to an organic EL device having high light emitting efficiency and excellent driving durability.

Description of the Related Art

There are known organic electroluminescent devices using a thin film material that is excited by passing an electric current therethrough and emits light. Since the organic EL devices allow light emission with high brightness to be obtained at low voltage, the organic EL devices provide a wide variety of potential uses in a wide range of fields including mobile phone displays, personal digital assistants (PDAs), computer displays, vehicle information displays, TV monitors, and general lightings, and have advantages such as thinning, weight reduction and miniaturization of the devices, as well as electrical power saving, in these fields. Therefore, the organic EL devices are highly expected to play a leading role in the future electronic display market. However, in order for the organic EL devices to be practically used in place of conventional displays in these fields, many technological improvements in terms of the brightness and color tone of the emitted light, durability under a wide range of environmental conditions, mass productivity at low cost, and the like remain as problems to be solved.

One of the problems particularly desired to be solved is an enhancement of the light emission efficiency and an improvement of the driving durability. When many of the devices described above are subject to thinning, weight reduction and miniaturization, it is primarily necessary to achieve high brightness. For thinning and weight reduction, compactification and weight reduction of not only the device but also of the driving power source are demanded. Particularly when the electric power is supplied from a primary cell or a secondary cell, electrical power saving is a significant problem, and it is strongly desired to obtain high brightness with low driving voltage. Conventionally, high voltage is required to achieve high brightness, thus resulting in increased electrical power consumption. Furthermore, high brightness and high voltage have resulted in an impairment of the durability of devices.

For this reason, there has been suggested an organic EL device in which a barrier that blocks the movement of holes and electrons is not provided between the respective layers interposed between a positive electrode and a negative electrode, such as a hole injection layer, a light emitting layer and an electron injection layer (see International Publication No. WO 2008/102644 ; and Adv. Mater., 2009, 21, 1-4). Furthermore, in order to increase the probability of hole-electron recombination in the light emitting layer, there have been suggested a method of including an electrically inert organic compound in the light emitting layer (see Japanese Patent Application Laid-Open (JP-A) No. 2005-294250), and a method of lowering the hole mobility and the electron mobility in the light emitting layer, as compared to the hole mobility in the adjacent hole transport layer and the electron mobility in the adjacent electron transport layer, respectively (see JP-A No. 2006-270091). There has been also suggested a method of trapping holes by incorporating two kinds of host materials having different degrees of hole mobility into the light emitting layer (see JP-A No. 2008-227462), or the like.

JP 2007 043130 A describes a composite material containing an organic compound. The article of Matsushima Toshinori et al.: "Enhancing power conversion efficiencies and operation stability of organic light-emitting diodes by increasing carrier injection efficiencies at anode/organic and organic/organic heterojunction interfaces", J. Appl. Phys., 2008, 104, pages 34507-1 - 34507-4, investigates the effect of the insertion of an ultrathin 0.75 nm thick HIL of $MoO_3$ between an ITO and an $\alpha$-NPD and of a 5 nm thick mixed layer between an $\alpha$-NPD and an $Alq_3$ on the performance of OLEDs.

US 2006/0273714 A1 discloses organic light emitting diodes comprising an emissive region, said region comprising a phosphorescent light emitting layer having intermediate layers of the same material on either side. Both Parshin et al. (Proc.of SPIE, 2006, 6192, pages 61922A-1 - 61922A-8) and Lee et al. (Mol. Cryst. Liq. Cryst., 2003, 405, pages 67-73) describe the charge carrier mobility in CBP films doped with $Ir(ppy)_3$.

However, under the current circumstances, a technology that is necessary when using a phosphorescent light emitting material is insufficient.

SUMMARY OF THE INVENTION

It is an object of the invention to provide an organic EL device which may achieve low driving voltage as well as maintain high light emission efficiency, and has satisfactory driving durability.

The inventors have conducted study in order to solve the problems, and as a result, they have found that in an

organic EL device having at least a positive electrode, a positive electrode-side intermediate layer, a light emitting layer, a negative electrode-side intermediate layer, and a negative electrode, when the ionization potentials of the main constituent material of the light emitting layer and the main constituent materials that constitute the respective positive electrode-side intermediate layers, and the electron affinities of the main constituent material of the light emitting layer and the main constituent materials constituting the respective negative electrode-side intermediate layers are controlled, the hole mobility and the electron mobility in the light emitting layer are controlled in certain ranges, and a compound having an ionization potential lower than the ionization potential of the main constituent material of the light emitting layer is incorporated into the light emitting layer in an amount of from 0.5% by mass to 20% by mass relative to the total mass of the light emitting layer, high efficiency and low driving voltage may be achieved.

The invention is based on the above findings made by the inventors, and exemplary embodiments to solve the problems are as follows.

<1> An organic electroluminescent device comprising:

a pair of electrodes composed of a positive electrode and a negative electrode;
a light emitting layer interposed between the electrodes;
at least one positive electrode-side intermediate layer interposed between the positive electrode and the light emitting layer; and
at least one negative electrode-side intermediate layer interposed between the negative electrode and the light emitting layer
wherein the following expressions (1) and (2) are satisfied

$$Ip(EML) - 0.1\ eV < Ip(1i) < Ip(EML) + 0.1\ eV \qquad (1)$$

$$Ea(EML) - 0.1\ eV < Ea(2i) < Ea(EML) + 0.1\ eV \qquad (2)$$

wherein Ip(EML) represents the ionization potential of the main constituent material of the light emitting layer, Ea(EML) represents the electron affinity of the main constituent material of the light emitting layer, Ip(1i) represents the ionization potential of the main constituent material of the at least one positive electrode-side intermediate layer, and Ea(2i) represents the electron affinity of the main constituent material of the at least one negative electrode-side intermediate layer;
the following expression (3) is satisfied

$$0.1 \leq \mu h/\mu e \leq 10 \qquad (3)$$

wherein $\mu h$ and $\mu e$ represent the hole mobility and the electron mobility of the light emitting layer at an electric field of $10^6$ V/cm, respectively; and
the light emitting layer contains a compound having an ionization potential lower than the ionization potential Ip(EML) of the main constituent material of the light emitting layer in an amount of from 0.5% by mass to 20% by mass relative to the total mass of the light emitting layer.

<2> The organic electroluminescent device of <1>, wherein a layer in contact with the positive electrode is p-doped.
<3> The organic electroluminescent device of <1> or <2>, wherein the at least one positive electrode-side intermediate layer includes a hole injection layer.
<4> The organic electroluminescent device of any one of <1> to <3>, wherein a layer in contact with the negative electrode is n-doped.
<5> The organic electroluminescent device of any one of <1> to <4>, wherein the at least one negative electrode-side intermediate layer includes an electron injection layer.
<6> An organic electroluminescent device comprising:

a pair of electrodes composed of a positive electrode and a negative electrode;
a light emitting layer interposed between the electrodes;
at least one positive electrode-side intermediate layer interposed between the positive electrode and the light emitting layer; and

at least one negative electrode-side intermediate layer interposed between the negative electrode and the light emitting layer
wherein the following expressions (1) and (2) are satisfied

$$Ip(EML) - 0.1\ eV < Ip(1i) < Ip(EML) + 0.1\ eV \quad (1)$$

$$Ea(EML) - 0.1\ eV < Ea(2i) < Ea(EML) + 0.1\ eV \quad (2)$$

wherein Ip(EML) represents the ionization potential of the main constituent material of the light emitting layer, Ea(EML) represents the electron affinity of the main constituent material of the light emitting layer, Ip(1i) represents the ionization potential of the main constituent material of the at least one positive electrode-side intermediate layer, and Ea(2i) represents the electron affinity of the main constituent material of the at least one negative electrode-side intermediate layer;
the following expression (3) is satisfied

$$0.1 \leq \mu h/\mu e \leq 10 \quad (3)$$

wherein $\mu h$ and $\mu e$ represent the hole mobility and the electron mobility of the light emitting layer at an electric field of $10^6$ V/cm, respectively; and
the light emitting layer contains an electrically inert material.

<7> The organic electroluminescent device of any one of <1> to <6>, wherein the at least one positive electrode-side intermediate layer, the light emitting layer and the at least one negative electrode-side intermediate layer are all organic layers.
<8> The organic electroluminescent device of <7>, wherein the main constituent materials of the organic layers are identical compounds.
<9> The organic electroluminescent device of <7> or <8>, wherein the main constituent materials of the organic layers are all carbazole compounds.

According to the invention, there is provided an organic EL device which may achieve low driving voltage as well as maintain high light emission efficiency, and has satisfactory driving durability.

BRIEF DESCRIPTION OF THE DRAWINGS

FIG. 1 is a schematic diagram showing an example of the layer structure of the organic EL device of the invention.

DETAILED DESCRIPTION OF THE INVENTION

(Constitution)

The organic EL device of the invention includes a light emitting layer between a pair of electrodes (positive electrode and negative electrode), and further includes a positive electrode-side intermediate layer between the positive electrode and the light emitting layer, and a negative electrode-side intermediate layer between the negative electrode and the light emitting layer.
In view of the nature of the light emitting device, it is preferable that at least one of the pair of electrodes be transparent.
As the positive electrode-side intermediate layer, there may be at least one layer between the positive electrode and the light emitting layer. There may also be plural layers such as a hole injection layer, a hole transport layer and other layers. These hole injection layer, hole transport layer and other layers are each referred to as a positive electrode-side intermediate layer. As a positive electrode-side intermediate layer, a hole injection layer is preferably included.
Furthermore, as the negative electrode-side intermediate layer, there may be at least one layer between the negative electrode and the light emitting layer. There may also be plural layers such as an electron injection layer, an electron transport layer and other layers. These electron injection layer, electron transport layer and other layers are each referred to as a negative electrode-side intermediate layer. As a negative electrode-side intermediate layer, an

electron injection layer is preferably included.

In a preferable embodiment, the organic EL device of the invention include, in sequence from the positive electrode side, (1) at least a hole injection layer (the hole injection layer and the hole transport layer may be combined into one layer), a light emitting layer, and an electron injection layer (the electron transport layer and the electron injection layer may be combined into one layer); (2) at least a hole injection layer, a hole transport layer (the hole injection layer and the hole transport layer may be combined into one layer), a light emitting layer, and an electron injection layer (the electron transport layer and the electron injection layer may be combined into one layer); (3) at least a hole injection layer, a light emitting layer, an electron transport layer, and an electron injection layer (the electron transport layer and the electron injection layer may be combined into one layer); (4) at least a hole injection layer, a hole transport layer (the hole injection layer and the hole transport layer may be combined into one layer), a light emitting layer, an electron transport layer, and an electron injection layer (the electron transport layer and the electron injection layer may be combined into one layer); or the like.

In the organic EL device of the invention, the hole injection layer, the hole transport layer, the light emitting layer, the electron transport layer and the electron injection layer may include plural layers therein, respectively. Furthermore, layers other than these layers may also be included in the organic EL device.

(Ionization potential, electron affinity)

In the organic EL device of the invention, the ionization potential Ip(1i) of the main constituent material of the positive electrode-side intermediate layer satisfies the following expression (1), and the electron affinity Ea(2i) of the main constituent material of the negative electrode-side intermediate layer satisfies the following expression (2):

$$\mathrm{Ip(EML)} - 0.1\ \mathrm{eV} < \mathrm{Ip(1i)} < \mathrm{Ip(EML)} + 0.1\ \mathrm{eV} \qquad (1)$$

$$\mathrm{Ea(EML)} - 0.1\ \mathrm{eV} < \mathrm{Ea(2i)} < \mathrm{Ea(EML)} + 0.1\ \mathrm{eV} \qquad (2)$$

wherein Ip(EML) represents the ionization potential of the main constituent material of the light emitting layer, Ea(EML) represents the electron affinity of the main constituent material of the light emitting layer, Ip(1i) represents the ionization potential of the main constituent material of the positive electrode-side intermediate layer, and Ea(2i) represents the electron affinity of the main constituent material of the negative electrode-side intermediate layer.

When there are plural positive electrode-side intermediate layers, it is required that the Ip(1i) values of the main constituent materials of the respective layers all satisfy the above expression (1). Furthermore, when there are plural negative electrode-side intermediate layers, it is required that the Ea(2i) values of the main constituent materials of the respective layers all satisfy the above expression (2).

Here, the main constituent material refers to a component with the largest mass (content) among the components in the layer.

Since the light emitting layer, positive electrode-side intermediate layer, and the negative electrode-side intermediate layer according to the invention satisfy the expression (1) and the expression (2) described above, the ionization potentials and the electron affinities of these layers are almost in the same levels. Therefore, there is no barrier with respect to the light emitting layer, and carriers such as holes and electrons may be injected therein. It is thought that as a result, the "accumulation of carriers at the interface of layers", which is believed to cause a decrease in the driving voltage, may be suppressed.

Furthermore, in the organic EL device of the invention, the following expression (3) is satisfied:

$$0.1 \leq \mu h/\mu e \leq 10 \qquad (3)$$

wherein $\mu h$ and $\mu e$ represent the hole mobility and the electron mobility of the light emitting layer at an electric field of $10^6$ V/cm, respectively.

More preferably, the expression $0.2 \leq \mu h/\mu e \leq 5$ is satisfied.

Furthermore, the light emitting layer in the organic EL device of the invention contains a compound having an ionization potential lower than the ionization potential Ip(EML) of the main constituent material of the light emitting layer in an amount of from 0.5% by mass to 20% by mass, and more preferably from 1.0% by mass to 10% by mass, relative to the total mass of the light emitting layer. When the content of the compound is in this range, the movement of the holes in the light emitting layer may be effectively suppressed.

When a positive electrode-side intermediate layer and a negative electrode-side intermediate layer having such an ionization potential and an electron affinity are provided, the hole mobility and the electron mobility in the light emitting layer satisfy the above expression (3), and the light emitting layer contains a compound having an ionization potential lower than the ionization potential Ip(EML) of the main constituent material of the light emitting layer in an amount of from 0.5% by mass to 20% by mass relative to the total mass of the light emitting layer, an organic EL device which may maintain high light emission efficiency and achieve low driving voltage, and also has satisfactory driving durability, may be provided.

Next, elements for constituting the organic EL device of the invention will be described below in detail.

<Light emitting layer>

The light emitting layer is a layer having a function of receiving, when an electric field is applied, holes from the positive electrode, the hole injection layer or the hole transport layer, while receiving electrons from the negative electrode, the electron injection layer or the electron transport layer, providing a place for the recombination of holes and electrons, and thereby emitting light.

The light emitting layer is not particularly limited and may be formed according to a known method, but the light emitting layer may be suitably formed by, for example, a dry film forming method such as a deposition method or a sputtering method, a wet coating method, a transfer method, a printing method, or an inkjet method.

The thickness of the light emitting layer is not particularly limited and may be appropriately selected according to the purpose. The thickness is preferably 2 nm to 500 nm, and from the viewpoint of the external quantum efficiency and driving voltage, the thickness is more preferably 3 nm to 200 nm, and even more preferably 10 nm to 100 nm. Furthermore, the light emitting layer may be a single layer or may be two or more layers, and the respective layers may emit light of different colors.

The light emitting layer according to the invention contains at least one light emitting material (light emitting dopant) and a host compound. As the light emitting dopant and the host compound contained in the light emitting layer according to the invention, a fluorescent light emitting dopant capable of emitting light from a singlet exciton (fluorescence), and a host compound may be combined, or a phosphorescent light emitting dopant capable of emitting light from a triplet exciton (phosphorescence), and a host compound may be combined.

The light emitting layer according to the invention may contain two or more kinds of light emitting dopants in order to enhance the color purity or to broaden the light emission wavelength region.

The light emitting layer of the invention contains a compound having an ionization potential lower than the ionization potential Ip(EML) of the main constituent material.

According to another preferred embodiment of the invention, the light emitting layer contains an electrically inert material instead of a compound having an ionization potential lower than the ionization potential Ip(EML) of the main constituent material.

(Light emitting dopant)

As the light emitting dopant according to the invention, a phosphorescent light emitting material, a fluorescent light emitting material and the like may be used as the dopant. The light emitting dopant is preferably a phosphorescent light emitting material.

<<Phosphorescent light emitting dopant>>

The phosphorescent light emitting dopant may be generally a complex containing a transition metal atom or a lanthanoid atom.

For example, the transition metal atom is not particularly limited, but preferable examples include ruthenium, rhodium, palladium, tungsten, rhenium, osmium, iridium and platinum. More preferable examples include rhenium, iridium and platinum, and even more preferable examples include iridium and platinum.

Examples of the lanthanoid atoms include lanthanum, cerium, praseodymium, neodymium, samarium, europium, gadolinium, terbium, dysprosium, holmium, erbium, thulium, ytterbium, and lutetium. Among these lanthanoid atoms, neodymium, europium and gadolinium are preferred.

Examples of the ligand of the complex include the ligands described in G. Wilkinson et al., "Comprehensive Coordination Chemistry", Pergamon Press, 1987; H. Yersin, "Photochemistry and Photophysics of Coordination Compounds", Springer-Verlag GmbH, 1987; Yamamoto Akio, "Organometallic Chemistry - Fundamentals and Applications -", Shokabo Publishing Co., Ltd., 1982; and the like.

Specific examples of the ligand include, preferably, a halogen ligand (preferably, a chlorine ligand), an aromatic carbocyclic ligand (for example, a cyclopentadienyl anion, a benzene anion, or a naphthyl anion), a nitrogen-containing

heterocyclic ligand (for example, phenylpyridine, benzoquinoline, quinolinol, bipyridyl, or phenanthroline), a diketone ligand (for example, acetylacetone), a carboxylic acid ligand (for example, an acetic acid ligand), an alcoholate ligand (for example, a phenolate ligand), a carbon monoxide ligand, an isonitrile ligand, and a cyano ligand, and a more preferred example is a nitrogen-containing heterocyclic ligand.

The complex may have one transition metal atom in the compound, or the complex may be a so-called polynuclear complex, which has two or more transition metal atoms. The complex may also simultaneously contain different kinds of metal atoms.

Among these, specific examples of the light emitting dopant include the phosphorescent light emitting compounds described in, for example, patent documents such as US 6303238 B1, US 6097147, WO 00/57676, WO 00/70655, WO 01/08230, WO 01/39234 A2, WO 01/41512 A1, WO 02/02714 A2, WO 02/15645 A1, WO 02/44189 A1, JP-A No. 2001-247859, Japanese Patent Application No. 2000-33561, JP-A No. 2002-117978, JP-A No. 2002-225352, JP-A No. 2002-235076, Japanese Patent Application No. 2001-239281, JP-A No. 2002-170684, EP 1211257, JP-A No. 2002-226495, JP-A No. 2002-234894, JP-A No. 2001-247859, JP-A No. 2001-298470, JP-A No. 2002-173674, JP-A No. 2002-203678, JP-A No. 2002-203679, JP-A No. 2004-357791, JP-A No. 2006-256999, and Japanese Patent Application No. 2005-75341. Among them, more preferable examples of the light emitting dopant that satisfies the expression (2) include an iridium (Ir) complex, a platinum (Pt) complex, a copper (Cu) complex, a rhenium (Re) complex, a tungsten (W) complex, a rhodium (Rh) complex, a ruthenium (Ru) complex, a palladium (Pd) complex, an osmium (Os) complex, an europium (Eu) complex, a terbium (Tb) complex, a gadolinium (Gd) complex, a dysprosium (Dy) complex, and a cerium (Ce) complex. Particularly preferable examples include an Ir complex, a Pt complex and a Re complex, and among them, an Ir complex, a Pt complex and a Re complex, which contain at least one coordination form selected from the metal-carbon bond, the metal-nitrogen bond, the metal-oxygen bond and the metal-sulfur bond, are preferred.

<<Fluorescent light emitting dopant>>

Examples of the fluorescent light emitting dopant generally include benzoxazoles, benzoimidazoles, benzothiazoles, styrylbenzenes, polyphenyls, diphenylbutadienes, tetraphenylbutadienes, naphthalimides, coumarins, pyranes, perinones, oxadiazoles, aldazines, pyralidines, cyclopentadienes, bisstyrylanthracenes, quinacridones, pyrrolopyridines, thiadiazolopyridines, cyclopentadienes, styrylamines, aromatic dimethylidine compounds, fused polycyclic aromatic compounds (anthracenes, phenanthrolines, pyrenes, perylenes, ruburenes, pentacenes, and the like), 8-quinolinol complexes, various metal complexes such as pyrromethene complexes and rare earth metal complexes, polymer compounds such as polythiophenes, polyphenylenes, and polyphenylenevinylenes, organic silanes, and derivatives thereof.

Among these, specific examples of the light emitting dopant include the following, but are not intended to be limited to these.

D-1

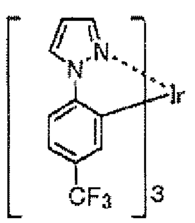

D-2

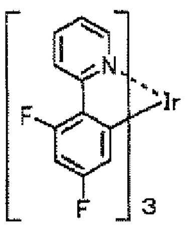

D-3

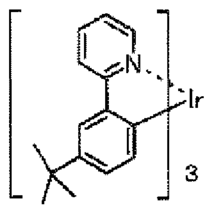

D-4

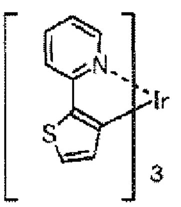

D-5

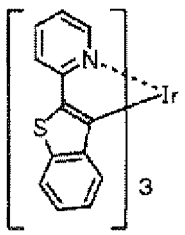

D-6

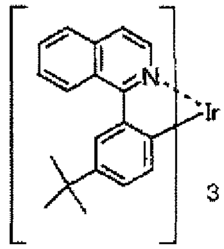

D-7

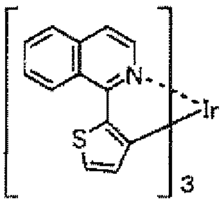

D-8

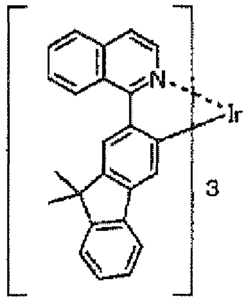

D-9

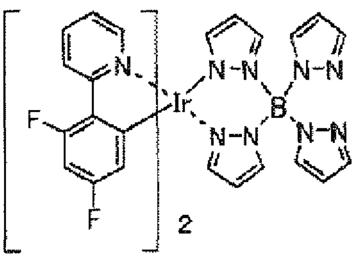

D-10

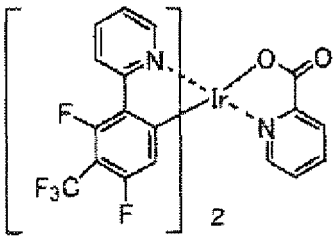

D-11

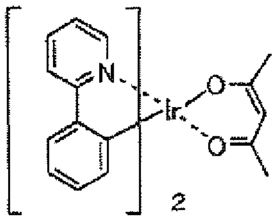

D-12

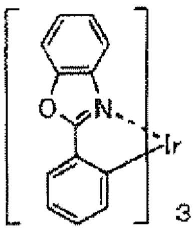

D-13

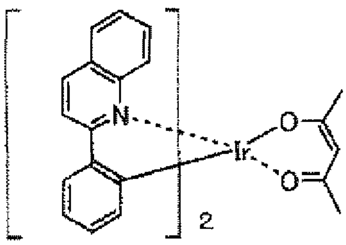

D-14

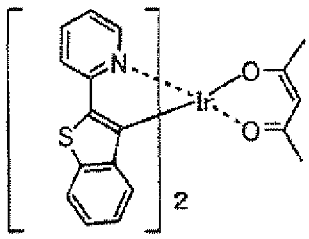

D-15

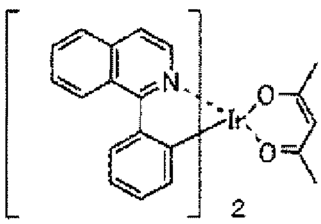

D-16

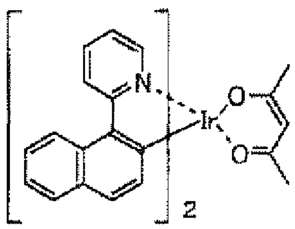

D-17

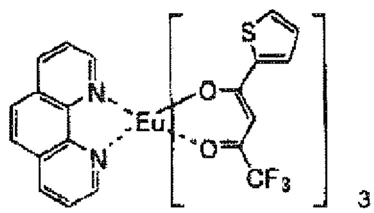

D-18

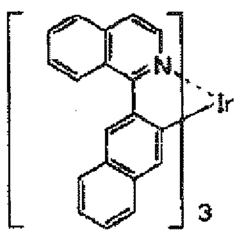

D-19

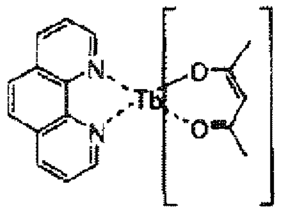

D-20

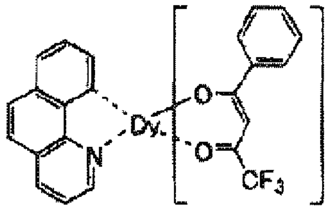

D-21

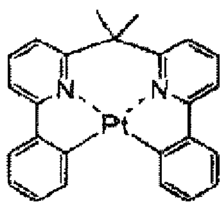

D-22

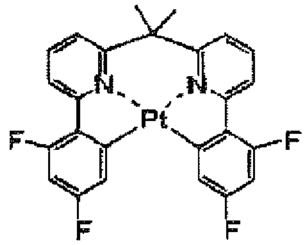

D-23

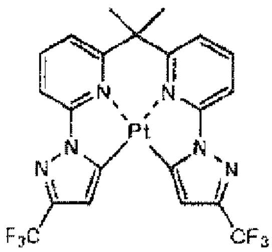

D-24

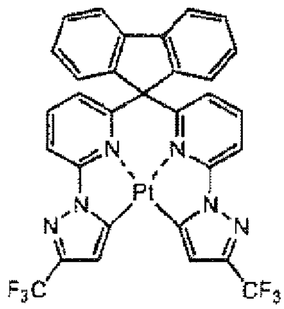

D-25

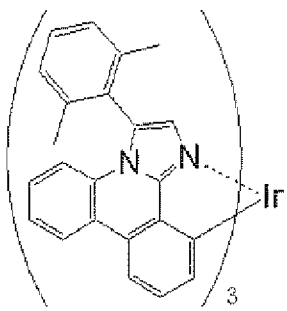

D-26

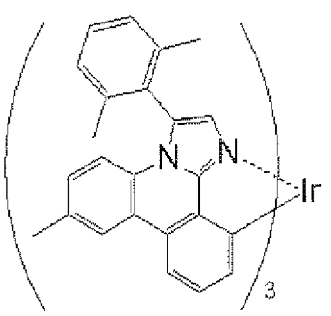

D-27

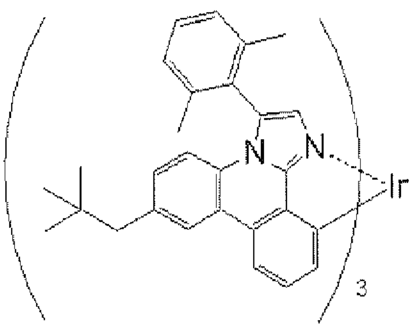

D-28

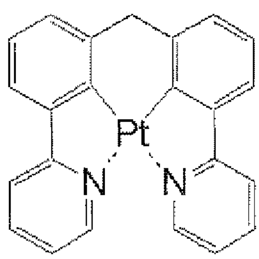

D-29

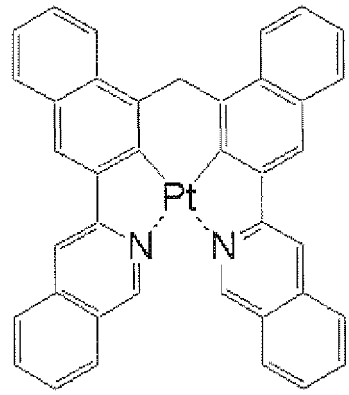

D-30

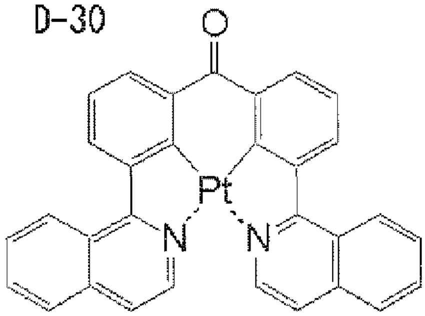

D-31

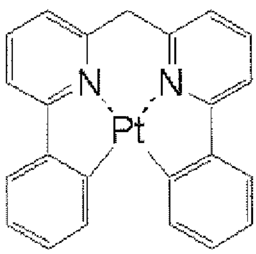

D-32

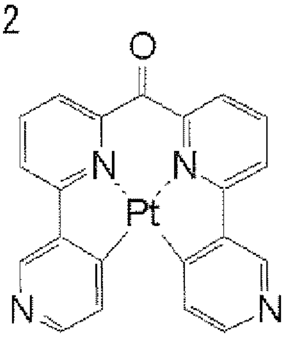

D-33

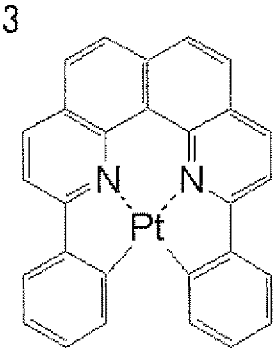

D-34

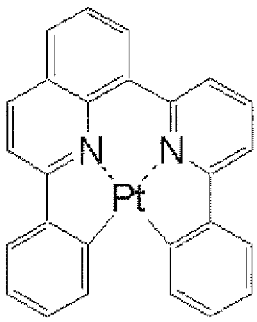

D-35

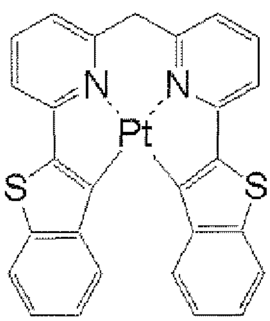

D-36

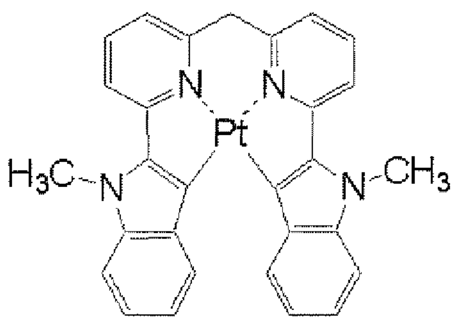

D-37

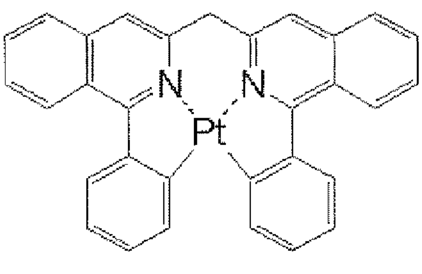

D-38

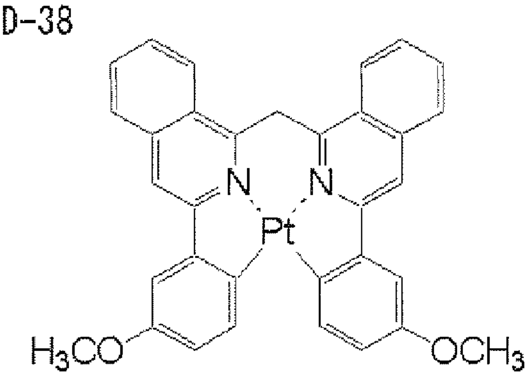

D-39

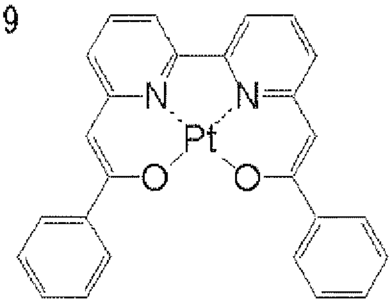

D-40

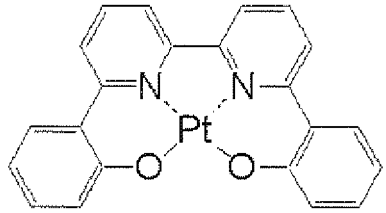

D-41

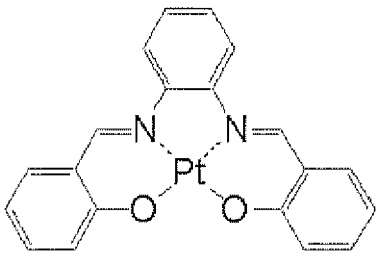

D-42

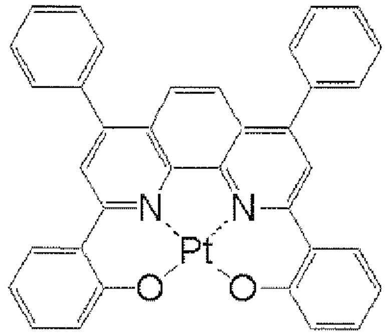

D-43

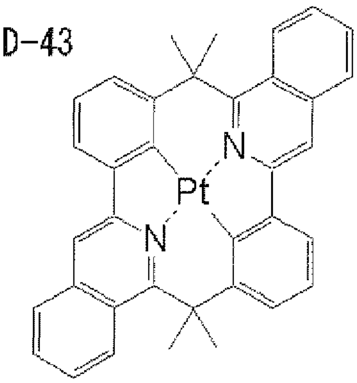

D-44

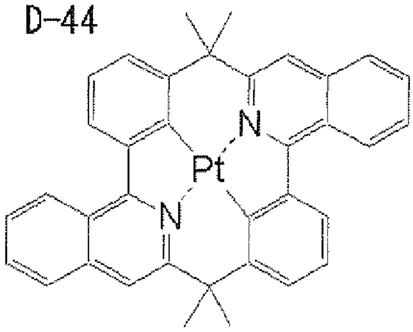

D-45

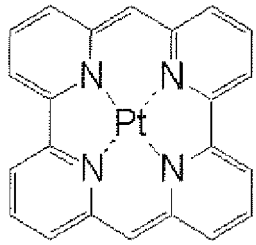

D-46

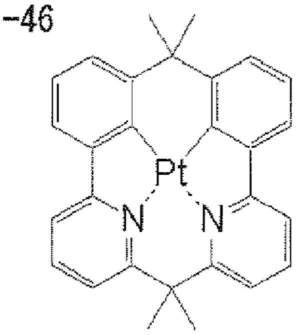

D-47

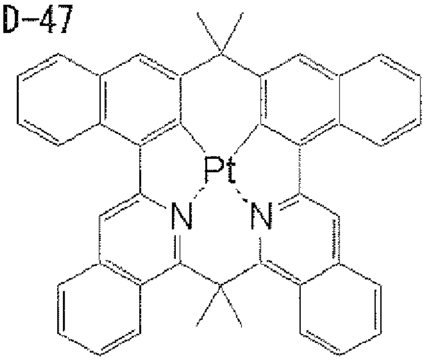

D-48

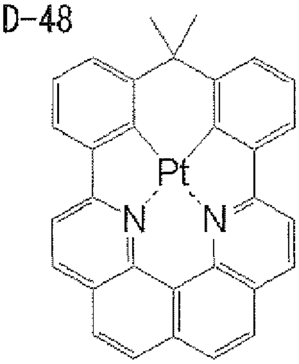

D-49

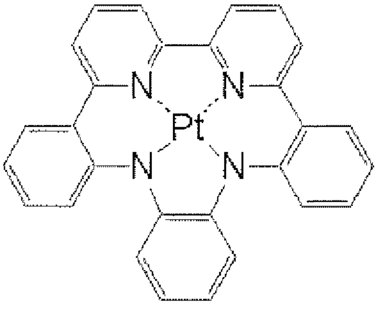

D-50

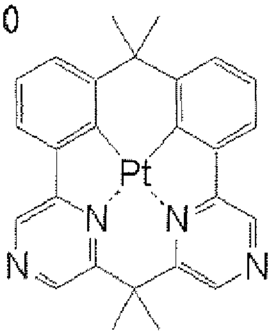

D-51

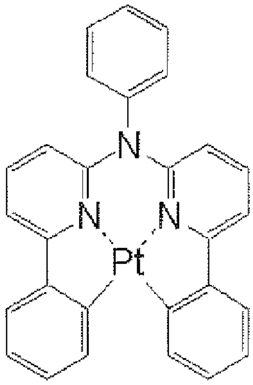

D-52

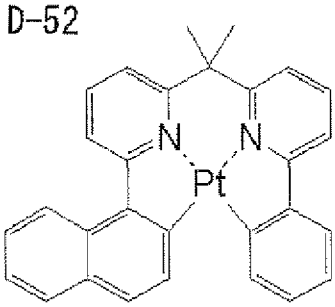

D-53

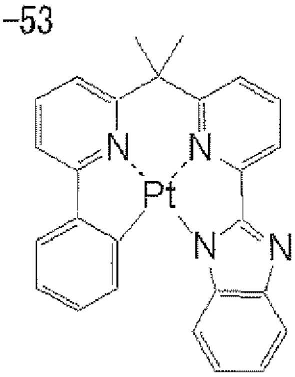

D-54

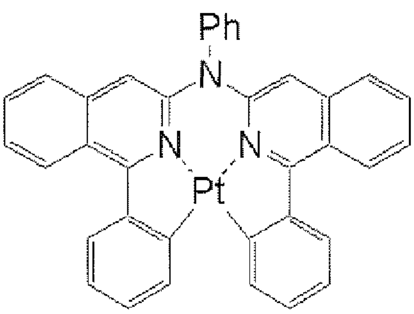

D-55

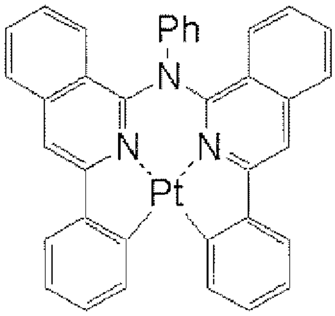

D-56

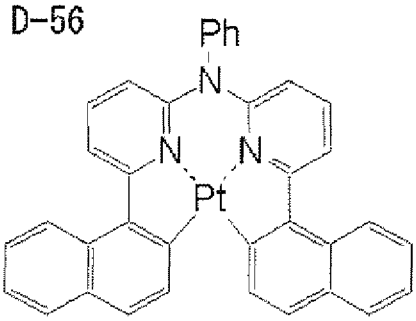

D-57

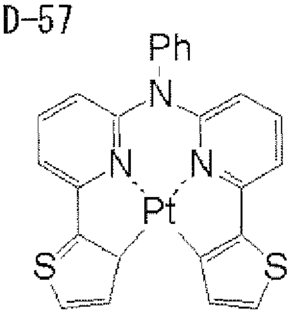

D-58

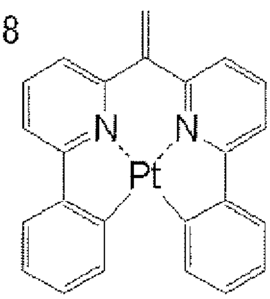

D-59

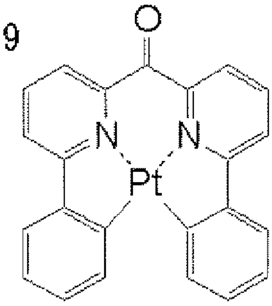

D-60

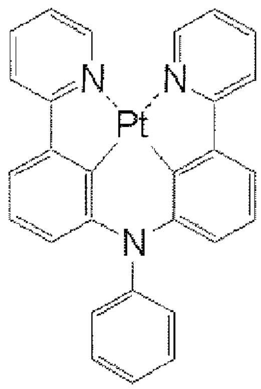

D-61

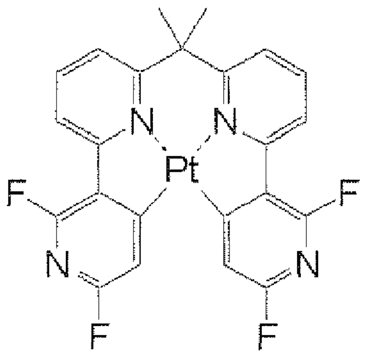

D-62

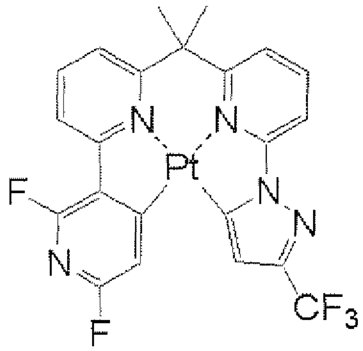

D-63

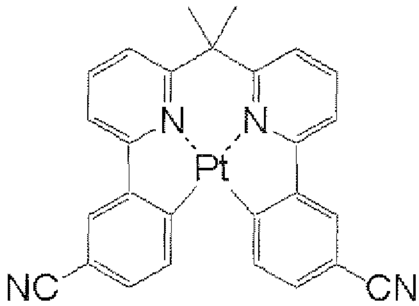

D-64

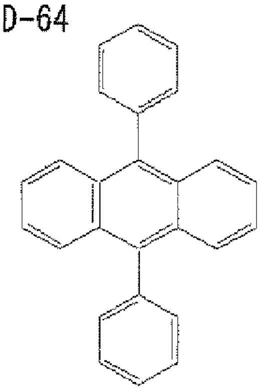

D-65

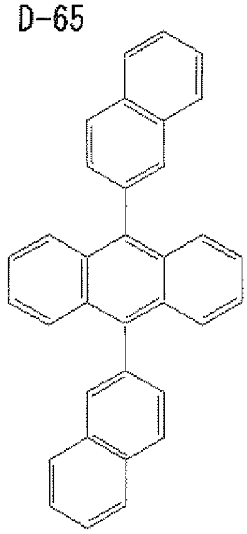

D-66

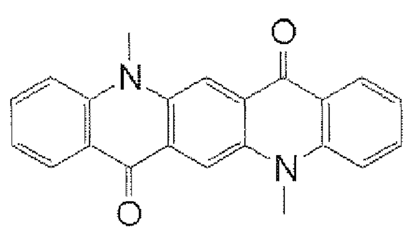

D-67

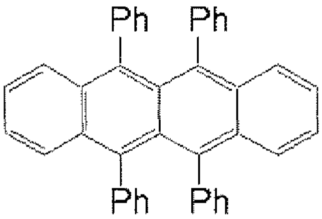

D-68

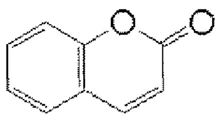

D-69

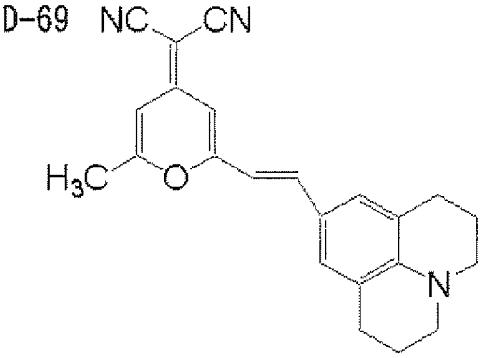

D-70

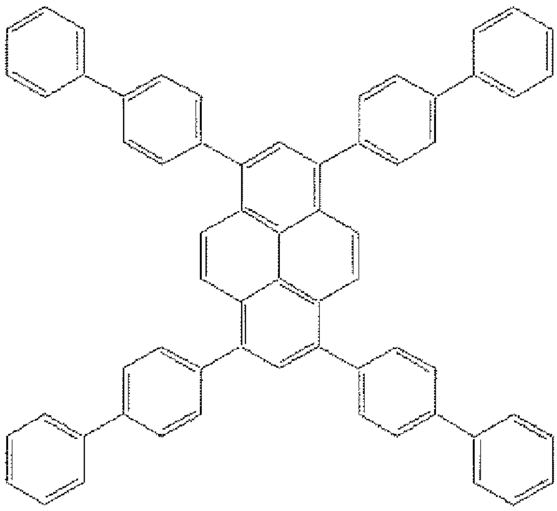

D-71

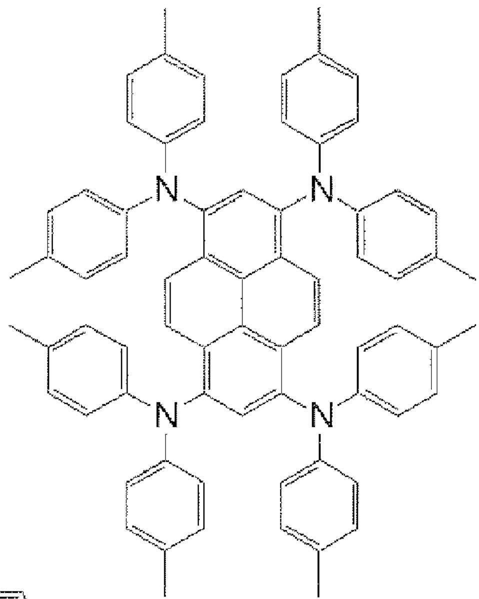

D-72

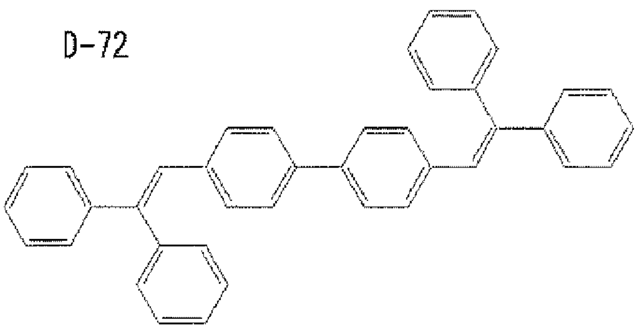

Among the compounds described above, D-2, D-3, D-4, D-5, D-6, D-7, D-8, D-9, D-10, D-11, D-12, D-13, D-14, D-15, D-16, D-21, D-22, D-23, D-24, D-25, D-26 and D-27 are preferred as the light emitting dopant to be used in the invention from the viewpoint of the light emission efficiency and durability, and D-2, D-3, D-4, D-5, D-6, D-7, D-8, D-12, D-13, D-14, D-15, D-16, D-21, D-22, D-23, D-24, D-25, D-26 and D-27 are more preferred, while D-13, D-21, D-22, D-23, D-24, D-25, D-26 and D-27 are even more preferred.

The light emitting dopant in the light emitting layer is contained in the light emitting layer, generally in an amount of 0.1% by mass to 50% by mass relative to the total mass of the compounds included in the light emitting layer, but from the viewpoint of durability and light emission efficiency, the light emitting dopant is contained preferably in an amount of 1% by mass to 40% by mass, and more preferably 2% by mass to 15% by mass.

<<Hole transporting host>>

The hole transporting host used in the light emitting layer of the invention has an Ip of preferably from 5.1 eV to 6.3 eV, more preferably from 5.4 eV to 6.1 eV, and even more preferably from 5.6 eV to 6.0 eV, from the viewpoint of enhancing the durability and lowering the driving voltage. Furthermore, from the viewpoint of enhancing the durability and lowering the driving voltage, the electron affinity Ea thereof is preferably from 1.2 eV to 3.1 eV, more preferably from 1.4 eV to 3.0 eV, and even more preferably from 1.8 V to 2.8 eV.

Specific examples of such a hole transporting host include the following materials:

pyrroles, carbazoles, azepines, carbenes, triazoles, oxazoles, oxadiazoles, pyrazoles, imidazoles, polyarylalkanes, pyrazolines, pyrazolones, phenylenediamines, arylamines, amino-substituted chalcones, styrylanthracenes, fluorenones, hydrazones, stilbenes, silazanes, aromatic tertiary amine compounds, styrylamine compounds, aromatic dimethylidene compounds, porphyrin compounds, polysilane compounds, poly(N-vinylcarbazole), aniline copolymers, conductive macromolecular oligomers such as thiophene oligomers and polythiophenes, organic silanes, carbon films, and derivatives thereof.

Among them, as a host material having a large ionization potential, a carbazole compound is preferred.

Specific examples of the hole transporting host include the following compounds but are not limited to these.

H-1

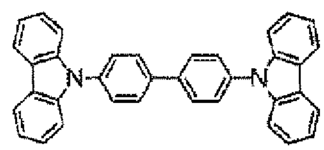

H-2

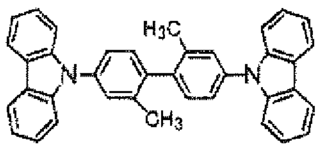

H-3

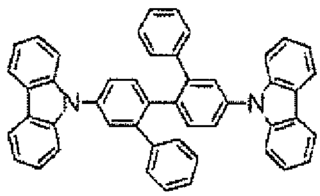

H-4

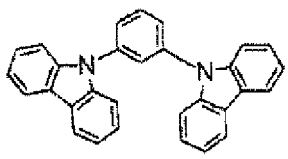

H-5

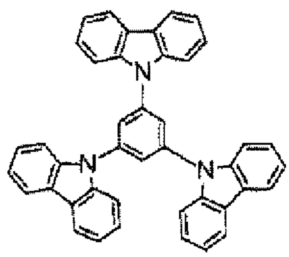

H-6

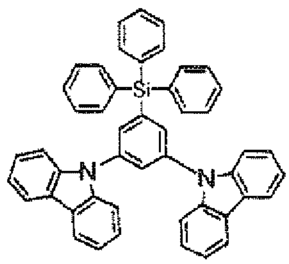

H-7

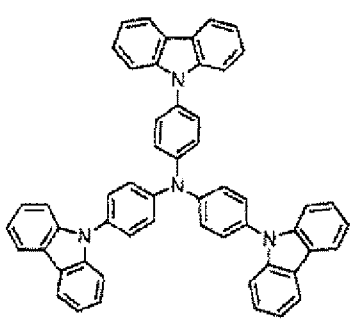

H-8

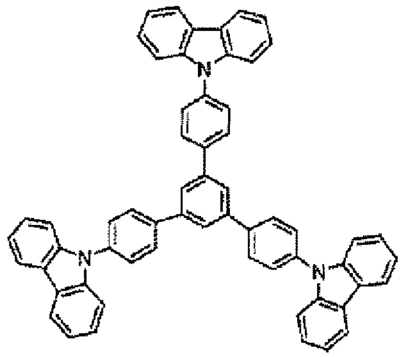

H-9

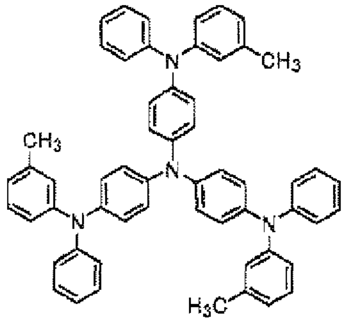

H-10

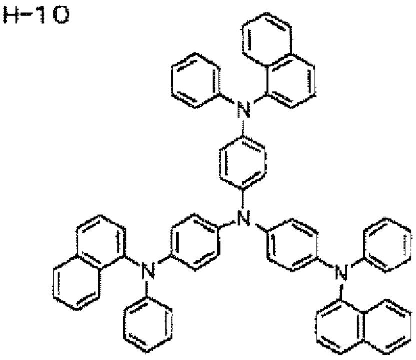

H-11

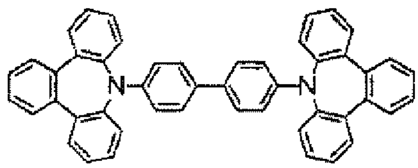

H-12

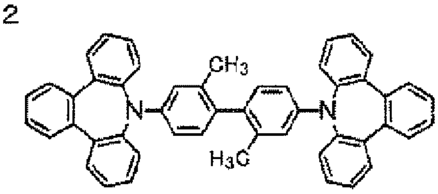

H-13

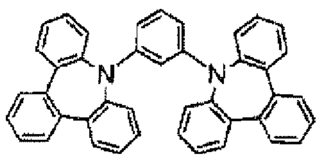

H-14

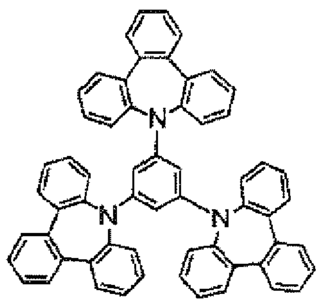

H-15

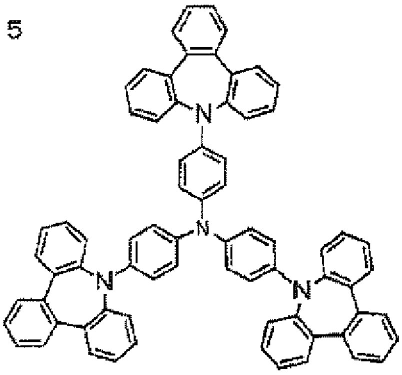

H-16

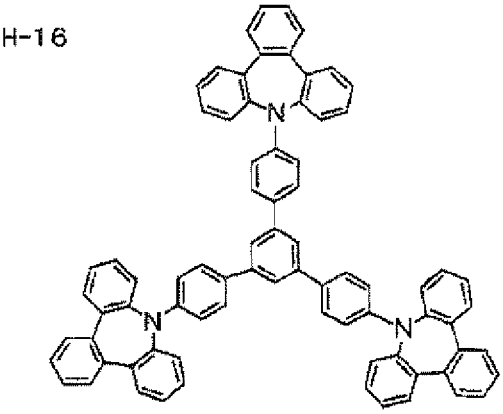

H-17

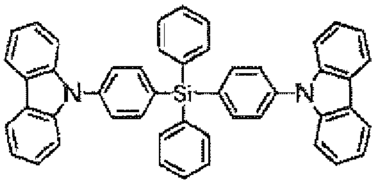

H-18

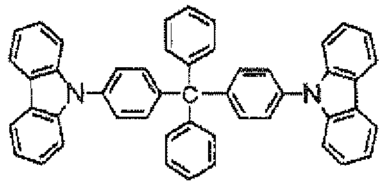

H-19

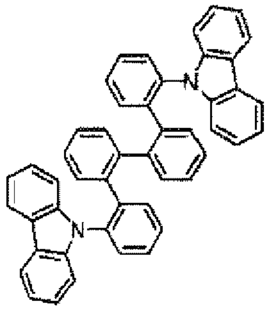

H-20

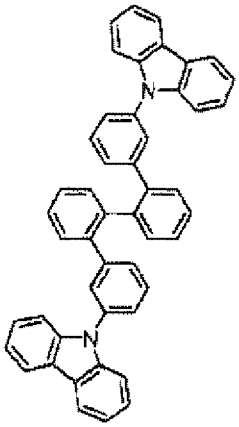

H-21

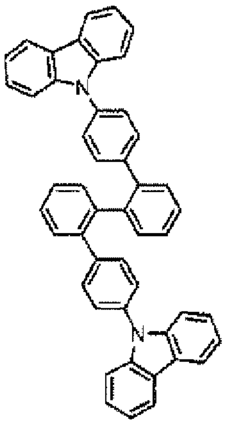

H-22

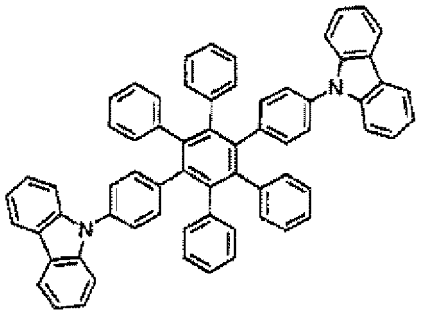

H-23

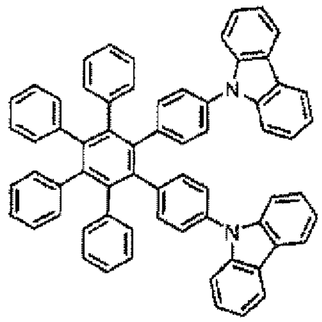

H-24

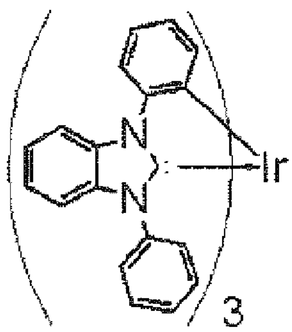

H-25

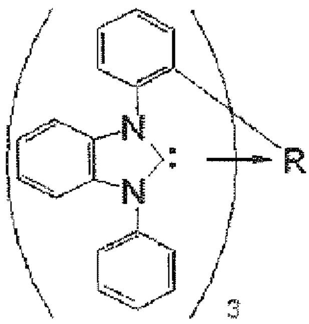

H-26

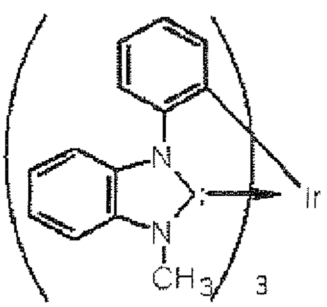

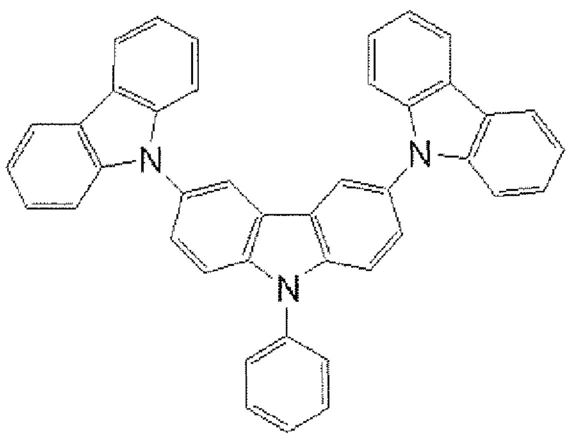

H-27

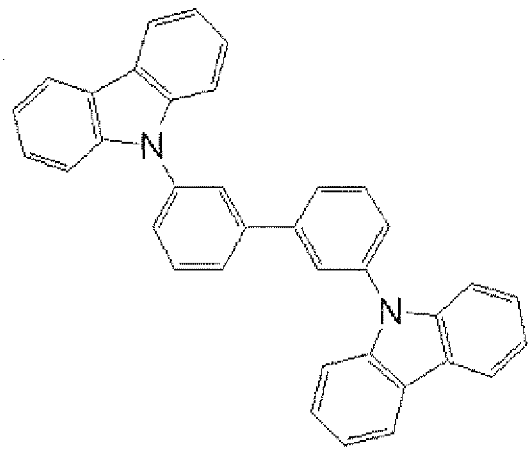

H-28

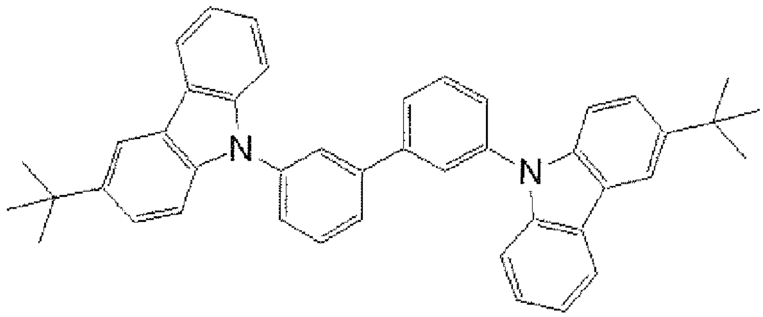

H-29

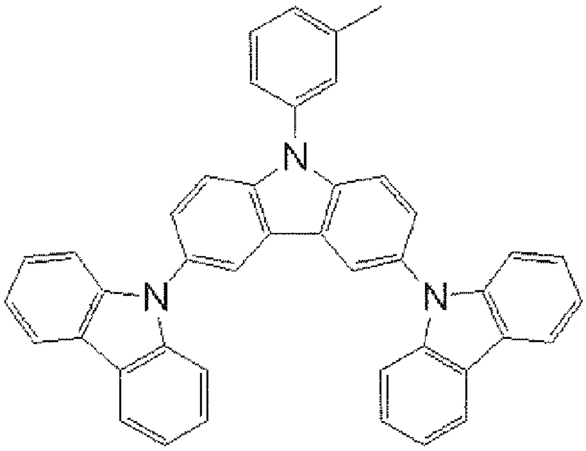

H-30

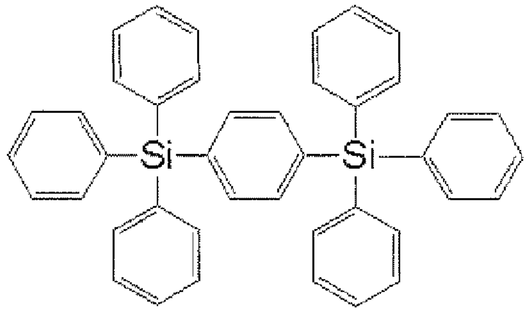

H-31

According to the invention, the light emitting layer contains a compound having an ionization potential lower than the ionization potential Ip(EML) of the main constituent material of the light emitting layer in an amount of from 0.5% by mass to 20% by mass relative to the total mass of the light emitting layer.

As the compound having an ionization potential lower than the ionization potential Ip(EML) of the main constituent material of the light emitting layer, any compound having an ionization potential lower than that of the main constituent material contained in the light emitting layer may be used irrespective of the type.

A compound which is selected from the hole transporting host materials mentioned above and has an ionization potential lower than that of the main constituent material contained in the light emitting layer may be preferably used, or a compound which is selected from the light emitting dopants mentioned above and has an ionization potential lower than that of the main constituent material contained in the light emitting layer may also be used.

Incorporating an electrically inert compound into the light emitting layer, instead of the compound having an ionization potential lower than the ionization potential Ip(EML) of the main constituent material of the light emitting layer, is another preferred embodiment of the invention.

An electrically inert material is a material which does not have charge transportability and does not directly contribute to light emission, but suppresses the exciton energy transfer. Such an electrically inert material is also called as a binder material, and is preferably an organic compound having an energy gap (Eg) between the highest occupied molecular orbital and the lowest unoccupied molecular orbital of 4.0 eV or greater. An organic compound having an Eg value of 4.0 eV or greater is generally electrically inert, and may exhibit an effect of blocking holes and/or electrons. The Eg value of the electrically inert material (hereinafter, appropriately referred to as a binder material) that is used in the invention is more preferably 4.1 eV or greater, and even more preferably 4.2 eV or greater.

Furthermore, it is preferable that the lowest excited triplet energy level (T1) of the binder material be higher than the T1 of the phosphorescent light emitting material contained in the same light emitting layer. For example, the T1 value of the blue phosphorescent light emitting material is approximately 2.6 eV, and in order to suppress the diffusion of the triplet exciton therefrom, the T1 of the binder material is higher than 2.6 eV, that is, preferably 2.7 eV or greater, and more preferably 2.9 eV or greater. Thereby, even when a green phosphorescent light emitting material or a red

phosphorescent light emitting material, which has smaller T1, is contained in the same light emitting layer in addition to the blue phosphorescent light emitting material, the exciton energy transfer from the blue phosphorescent light emitting material to the green phosphorescent light emitting material or the red phosphorescent light emitting material is more effectively suppressed, and thus the collapse of the color balance may be more certainly suppressed.

Furthermore, the ionization potential (Ip) of the binder material is preferably 6.1 eV or greater. It is preferable for the light emitting layer to contain a binder material having such an Ip, since the movement of holes from the light emitting material in the light emitting layer is suppressed, and the light emission efficiency may be further enhanced. Furthermore, the Ip of the binder material is more preferably 6.2 eV or greater, and even more preferably 6.3 eV or greater. Particularly, when the light emitting material is a blue phosphorescent light emitting material, the ionization potential thereof is 5.8 eV to 6.0 eV, and in order to prevent the movement of holes from this blue phosphorescent light emitting material to the electrically inert organic compound, the ionization potential of the electrically inert organic compound is preferably higher than the above range, that is, 6.1 eV or greater. Thereby, even when the light emitting layer contains a blue phosphorescent light emitting material, the blue light emission efficiency may be further enhanced. When using a phosphorescent light emitting material, the ionization potential of N,N'-dicarbazolyl-1,3-benzene (abbreviated as mCP), which is widely used as a host material in the light emitting layer, is 5.9 eV and in order to suppress the leakage of holes from mCP of the light emitting layer to the negative electrode-side adjacent layer, it is preferable that the Ip of the binder material be larger than the Ip of mCP. When the Ip of the binder material is 6.1 eV or greater, the leakage of holes as described above may be suppressed, and the light emission efficiency may be further enhanced.

The electron affinity (Ea) of the binder material is preferably 2.3 eV or less. It is preferable to use a binder material having such an Ea value, since the leakage of electrons from the light emitting layer (mainly, leakage of electrons from the host material of the light emitting layer) is suppressed, and the light emission efficiency may be further enhanced. The electron affinity of mCP, which is widely used as a host material in the light emitting layer, is 2.4 eV, and in order to suppress the leakage of electrons from mCP of the light emitting layer to the positive electrode-side adjacent layer, it is preferable that the Ea of the binder material be smaller than the Ea of mCP. When the Ea of the binder material is 2.3 eV or less, the leakage of electrons may be suppressed, and the light emission efficiency may be further enhanced.

As the binder material for constituting the light emitting layer according to the invention, one kind of material may be used, or plural kinds of materials may be used. When plural kinds of binder materials are used in mixture, the mixing ratio as a mass ratio is preferably in the range of from 1:99 to 50:50, and more preferably in the range of from 20:80 to 50:50. When plural kinds of binder materials are used in mixture, the movement of excitons may be suppressed, and an enhancement of the light emission efficiency and an enhancement of the driving durability may also be achieved.

The compounds described in JP-A No. 2009-32976 may be listed as specific examples of the binder material related to the invention.

The electrically inert material contained in the light emitting layer is preferably contained in an amount in the range of from 5% to 80% by mass, and more preferably in the range of from 10% to 50% by mass, based on the light emitting layer. When the electrically inert compound is contained in this range, the movement of holes and electrons in the light emitting layer may be effectively suppressed.

<<Electron transporting host>>

As the host material that is used in the invention, an electron transporting host compound having excellent electron transportability (may be described as electron transporting host) may be used, together with the hole transporting host material having excellent hole transportability.

The electron transporting host in the light emitting layer that is used in the invention has an electron affinity Ea of preferably from 2.5 eV to 3.5 eV, and more preferably from 2.6 eV to 3.2 eV, from the viewpoint of enhancing durability and lowering the driving voltage. Furthermore, from the viewpoint of enhancing durability and lowering the driving voltage, the ionization potential Ip thereof is preferably from 5.7 eV to 7.5 eV, and more preferably from 5.8 eV to 7.0 eV.

Specific examples of such an electron transporting host include the following materials:
pyridines, pyrimidines, triazines, imidazoles, pyrazoles, triazoles, oxazoles, oxadiazoles, fluorenones, anthraquinodimethanes, anthrones, diphenylquinones, thiopyrane dioxides, carbodiimides, fluorenylidenemethanes, distyrylpyrazines, fluorine-substituted aromatic compounds, tetracarboxylic acid anhydrides of naphthalenes or perylenes, phthalocyanines, and derivatives thereof (may form a fused ring with other rings), and various metal complexes such a metal complex of an 8-quinolinol derivative, a metallophthalocyanine and a metal complex having a benzoxazole or a benzothiazole as a ligand.

Preferable examples of the electron transporting host include a metal complex, an azole derivative (a benzimidazole derivative, an imidazopyridine derivative, or the like), and an azine derivative (a pyridine derivative, a pyrimidine derivative, a triazine derivative, or the like), and among them, a metal complex compound is preferred in view of durability for the invention. As the metal complex compound, a metal complex having a ligand including at least one nitrogen, oxygen or sulfur atom coordinated to a metal atom is more preferred.

The metal ion in the metal complex is not particularly limited, but is preferably a beryllium ion, a magnesium ion, an aluminum ion, a gallium ion, a zinc ion, an indium ion, a tin ion, a platinum ion, or a palladium ion. The metal ion is more preferably a beryllium ion, an aluminum ion, a gallium ion, a zinc ion, a platinum ion or a palladium ion, and even more preferably an aluminum ion, a zinc ion or a palladium ion.

As the ligand that is contained in the metal complexes, there are available various known ligands, and examples include the ligands described in H. Yersin, "Photochemistry and Photophysics of Coordination Compounds", Springer-Verlag GmbH, 1987; Yamamoto Akio, "Organometallic Chemistry - Fundamentals and Applications -", Shokabo Publishing Co., Ltd., 1982; and the like.

The ligand is preferably a nitrogen-containing heterocyclic ligand (preferably having 1 to 30 carbon atoms, more preferably 2 to 20 carbon atoms, and even more preferably 3 to 15 carbon atoms), and the ligand may be a monodentate ligand or a bidentate or higher-dentate ligand. Preferably, the ligand is a bidentate to hexadentate ligand. Furthermore, a combination of a bidentate to hexadentate ligand and a monodentate ligand is also preferable.

Examples of the ligand include an azine ligand (examples include a pyridine ligand, a bipyridyl ligand, and a terpyridine ligand), a hydroxyphenylazole ligand (examples include a hydroxyphenylbenzimidazole ligand, a hydroxyphenylbenzoxazole ligand, a hydroxyphenylimidazole ligand, and a hydroxyphenylimidazopyridine ligand), an alkoxy ligand (preferably having 1 to 30 carbon atoms, more preferably 1 to 20 carbon atoms, and even more preferably 1 to 10 carbon atoms, and examples include methoxy, ethoxy, butoxy, and 2-ethylhexyloxy), an aryloxy ligand (preferably having 6 to 30 carbon atoms, more preferably 6 to 20 carbon atoms, and even more preferably 6 to 12 carbon atoms, and examples include phenyloxy, 1-naphthyloxy, 2-naphthyloxy, 2,4,6-trimethylphenyloxy, and 4-biphenyloxy),

a heteroaryloxy ligand (preferably having 1 to 30 carbon atoms, more preferably 1 to 20 carbon atoms, and even more preferably 1 to 12 carbon atoms, and examples include pyridyloxy, pyrazyloxy, pyrimidyloxy and quinolyloxy), an alkylthio ligand (preferably having 1 to 30 carbon atoms, more preferably 1 to 20 carbon atoms, and even more preferably 1 to 12 carbon atoms, and examples include methylthio, and ethylthio), an arylthio ligand (preferably having 6 to 30 carbon atoms, more preferably 6 to 20 carbon atoms, and even more preferably 6 to 12 carbon atoms, and examples include phenylthio), a heteroarylthio ligand (preferably having 1 to 30 carbon atoms, more preferably 1 to 20 carbon atoms, and even more preferably 1 to 12 carbon atoms, and examples include pyridylthio, 2-benzimidazolylthio, 2-benzoxazolylthio, and 2-benzothiazolylthio), a siloxy ligand (preferably having 1 to 30 carbon atoms, more preferably 3 to 25 carbon atoms, and even more preferably 6 to 20 carbon atoms, and examples include a triphenylsiloxy group, a triethoxysiloxy group, and a triisopropylsiloxy group), an aromatic hydrocarbon anion ligand (preferably having 6 to 30 carbon atoms, more preferably 6 to 25 carbon atoms, and even more preferably 6 to 20 carbon atoms, and examples include a phenyl anion, a naphthyl anion, and an anthranyl anion), an aromatic heterocyclic anion ligand (preferably having 1 to 30 carbon atoms, more preferably 2 to 25 carbon atoms, and even more preferably 2 to 20 carbon atoms, and examples include a pyrrole anion, a pyrazole anion, a triazole anion, an oxazole anion, a benzoxazole anion, a thiazole anion, a benzothiazole anion, a thiophene anion, and a benzothiophene anion), and an indolenine anion ligand. Preferable examples include a nitrogen-containing heterocyclic ligand, an aryloxy ligand, a heteroaryloxy ligand, a siloxy ligand, an aromatic hydrocarbon anion ligand, and an aromatic heterocyclic anion ligand, and more preferable examples include a nitrogen-containing heterocyclic ligand, an aryloxy ligand, a siloxy ligand, an aromatic hydrocarbon anion ligand, and an aromatic heterocyclic anion ligand.

Examples of the metal complex electron transporting host include the compounds described in JP-A No. 2002-235076, JP-A No. 2004-214179, JP-A No. 2004-221062, JP-A No. 2004-221065, JP-A No. 2004-221068, and JP-A No. 2004-327313.

Specific examples of such an electron transporting host include the following materials, but are not intended to be limited to these.

E-1

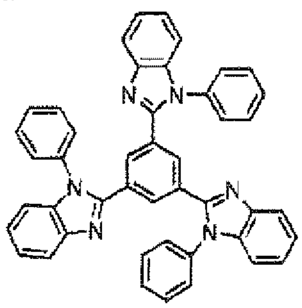

E-2

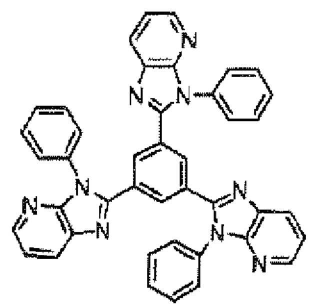

E-3

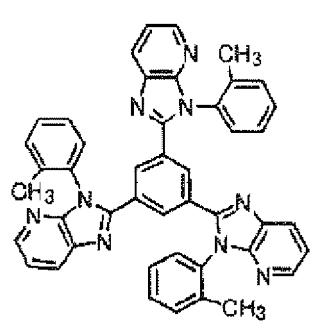

E-4

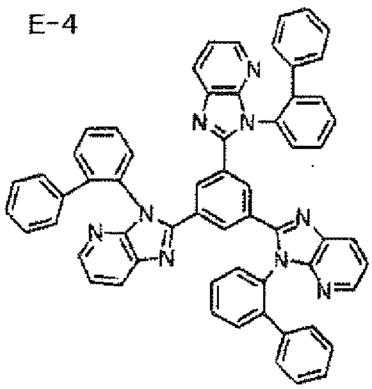

E-5

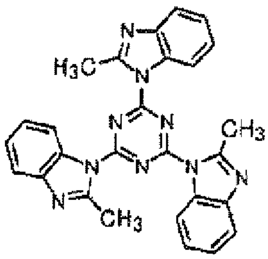

E-6

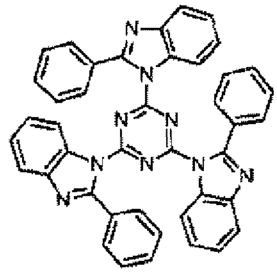

E-7

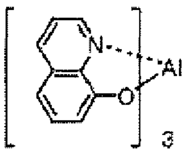

E-8

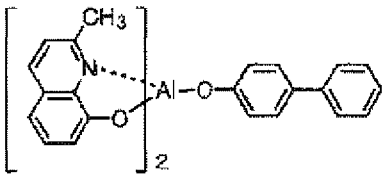

E-9

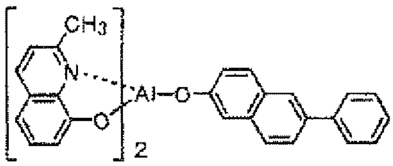

E-10

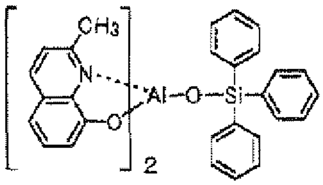

E-11

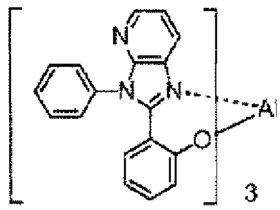

E-12

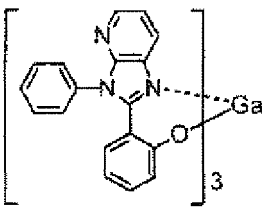

E-13

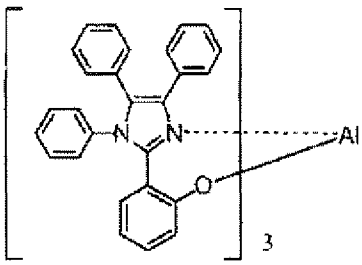

E-14

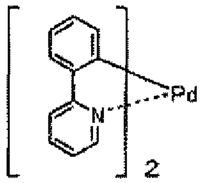

E-15

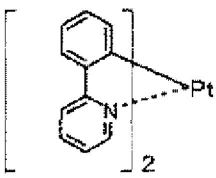

E-16

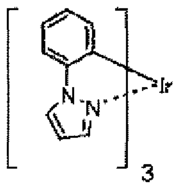

E-17

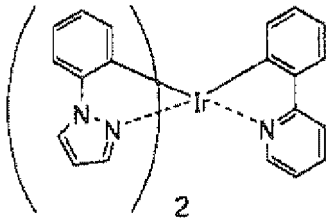

E-18

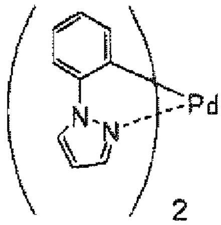

E-19

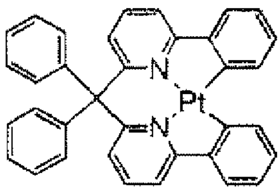

E-20

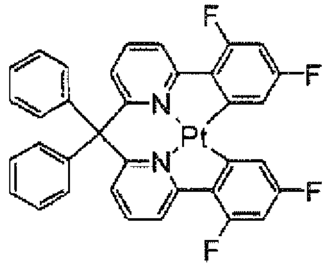

E-21

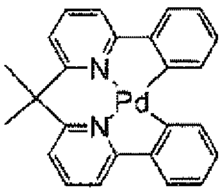

E-22

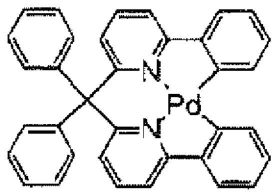

As the electron transporting host, E-1 to E-6, E-8, E-9, E-10, E-21, and E-22 are preferred; E-3, E-4, E-6, E-8, E-9, E-10, E-21, and E-22 are more preferred; and E-3, E-4, E-21, and E-22 are even more preferred.

The content of the host compound according to the invention is not particularly limited, but from the viewpoint of the light emission efficiency and the driving voltage, the content is preferably from 15% by mass to 95% by mass relative to the total mass of the compounds included in the light emitting layer.

Furthermore, a host material obtainable by substituting a part or all of hydrogen of the host material with deuterium, may also be used (Japanese Patent Application No. 2008-126130 and Japanese National Phase Publication (Laid-Open) No. 2004-515506).

<Positive electrode-side intermediate layer>

As the positive electrode-side intermediate layer, a hole injection layer and optionally a hole transport layer are included. The hole injection layer and the hole transport layer are layers having a function of receiving holes from the positive electrode or the positive electrode side and transporting them to the negative electrode side. The hole injection layer and the hole transport layer may each have a single-layer structure, or a multilayer structure composed of plural layers having identical compositions or different compositions.

The hole injection material or the hole transporting material used in these layers may be a low molecular weight compound, or may be a high molecular weight compound.

In particular, it is preferable that the layer in contact with the positive electrode be p-doped. As the dopant to be introduced into the hole injection layer or the hole transport layer, an inorganic compound as well as an organic compound may be used, as long as the compound is an electron-accepting compound and has a property of oxidizing an organic compound.

The inorganic compound is not particularly limited, and may be appropriately selected according to the purpose. Examples thereof include metal halides such as ferric chloride, aluminum chloride, gallium chloride, indium chloride and antimony pentachloride; and metal oxides such as vanadium pentoxide and molybdenum trioxide.

The organic compound is not particularly limited, and may be appropriately selected according to the purpose. Examples thereof include compounds having a substituent such as a nitro group, a halogen atom, a cyano group, or a trifluoromethyl group; a quinone compound, an acid anhydride compound, and fullerene.

Specific examples include hexacyanobutadiene, hexacyanobenzene, tetracyanoethylene, tetracyanoquinodimethane, tetrafluorotetracyanoquinodimethane, p-fluoranil, p-chloranil, p-bromanil, p-benzoquinone, 2,6-dichlorobenzoquinone, 2,5-dichlorobenzoquinone, tetramethylbenzoquinone, 1,2,4,5-tetracyanobenzene, o-dicyanobenzene, p-dicyanobenzene, 1,4-dicyanotetrafluorobenzene, 2,3-dichloro-5,6-dicyanobenzoquinone, p-dinitrobenzene, m-dinitrobenzene, o-dinitrobenzene, p-cyanonitrobenzene, m-cyanonitrobenzene, o-cyanonitrobenzene, 1,4-naphthoquinone, 2,3-dichloronaphthoquinone, 1-nitronaphthalene, 2-nitronaphthalene, 1,3-dinitronaphthalene, 1,5-dinitronaphthalene, 9-cyanoanthracene, 9-nitroanthracene, 9,10-anthraquinone, 1,3,6,8-tetranitrocarbazole, 2,4,7-trinitro-9-fluorenone, 2,3,5,6-tetracyanopyridine, maleic anhydride, phthalic anhydride, C60 and C70.

Among these, preferable examples include hexacyanobutadiene, hexacyanobenzene, tetracyanoethylene, tetracyanoquinodimethane, tetrafluorotetracyanoquinodimethane, p-fluoranil, p-chloranil, p-bromanil, p-benzoquinone, 2,6-dichlorobenzoquinone, 2,5-dichlorobenzoquinone, 1,2,4,5-tetracyanobenzene, 1,4-dicyanotetrafluorobenzene, 2,3-dichloro-5,6-dicyanobenzoquinone, p-dinitrobenzene, m-dinitrobenzene, o-dinitrobenzene, 1,4-naphthoquinone, 2,3-dichloronaphthoquinone, 1,3-dinitronaphthalene, 1,5-dinitronaphthalene, 9,10-anthraquinone, 1,3,6,8-tetranitrocarbazole, 2,4,7-trinitro-9-fluorenone, 2,3,5,6-tetracyanopyridine, and C60; and particularly preferable examples include hexacyanobutadiene, hexacyanobenzene, tetracyanoethylene, tetracyanoquinodimethane, tetrafluorotetracyanoquinodimethane, p-fluoranil, p-chloranil, p-bromanil, 2,6-dichlorobenzoquinone, 2,5-dichlorobenzoquinone, 2,3-dichloronaphthoquinone, 1,2,4,5-tetracyanobenzene, 2,3-dichloro-5,6-dicyanobenzoquinone, and 2,3,5,6-tetracyanopyridine.

These electron-accepting dopants may be used singly, or may be used in combination of two or more kinds. The amount of use of the electron-accepting dopant may vary with the kind of the material, but the amount of use is preferably 0.01% by mass to 50% by mass, more preferably 0.05% by mass to 40% by mass, and even more preferably 0.1% by mass to 30% by mass, based on the hole injection layer material. If the amount of use is less than 0.01% by mass based on the hole injection material, the effects of the invention may be insufficient, and if the amount of use exceeds 50% by mass, the hole injection capability may be impaired.

When the hole injection layer contains an acceptor, it is preferable that the hole transport layer substantially does not contain an acceptor.

Examples of the hole injection material and the hole transporting material include pyrroles, indoles, carbazoles, azaindoles, azacarbazoles, pyrazoles, imidazoles, polyarylalkanes, pyrazolines, pyrazolones, phenylenediamines, arylamines, amino-substituted chalcones, styrylanthracenes, fluorenones, hydrazones, stilbenes, silazanes, an aromatic tertiary amine compound, a styrylamine compound, an aromatic dimethylidine compound, a porphyrin compound, a polysilane compound, poly(N-vinylcarbazole), an aniline copolymer, a conductive macromolecular oligomer such as a thiophene oligomer or a polythiophene, an organic silane, a carbon film, and derivatives thereof.

Among these, an indole compound, a carbazole compound, an azaindole compound, an azacarbazole compound, an aromatic tertiary amine compound, and a thiophene compound are preferred, and compounds having a plural number of an indole skeleton, a carbazole skeleton, an azaindole skeleton, an azacarbazole skeleton or an aromatic tertiary amine skeleton in the molecule, are preferred, while a carbazole compound is preferred.

The hole injection layer and the hole transport layer may be formed according to a known method, but the layers may be suitably formed by, for example, a dry film forming method such as a deposition method or a sputtering method, a wet coating method, a transfer method, a printing method, or an inkjet method.

The thickness of the hole injection layer and the hole transport layer is not particularly limited, but from the viewpoint of lowering the driving voltage, the thickness is preferably 1 nm to 500 nm, more preferably 5 nm to 300 nm, and even more preferably 10 nm to 150 nm.

The hole injection layer and the hole transport layer may have a single-layer structure composed of one kind or two or more kinds of the materials described above, or may have a multilayer structure formed of plural layers having an identical composition or different compositions.

The carrier mobility in the hole transport layer is generally from $10^{-7}$ $cm^2 \cdot V^{-1} \cdot s^{-1}$ to $10^{-1}$ $cm^2 \cdot V^{-1} \cdot s^{-1}$, and among others, in view of the light emission efficiency, the carrier mobility is preferably from $10^{-5}$ $cm^2 \cdot V^{-1} \cdot s^{-1}$ to $10^{-1}$ $cm^2 \cdot V^{-1} \cdot s^{-1}$, more preferably from $10^{-4}$ $cm^2 \cdot V^{-1} \cdot s^{-1}$ to $10^{-1}$ $cm^2 \cdot V^{-1} \cdot s^{-1}$, and even more preferably from $10^{-3}$ $cm^2 \cdot V^{-1} \cdot s^{-1}$ to $10^{-1}$ $cm^2 \cdot V^{-1} \cdot s^{-1}$.

For the carrier mobility, a value measured by the same method as the method for measuring the carrier mobility of the light emitting layer is employed.

<Negative electrode-side intermediate layer>

As the negative electrode-side intermediate layer, an electron injection layer and optionally an electron transport layer are included. The electron injection layer and the electron transport layer may be formed according to a known

method, but these layers may be suitably formed by, for example, a deposition method, a wet film forming method, a molecular beam epitaxy (MBE) method, a cluster ion beam method, a molecular accumulation method, a Langmuir-Blodgett (LB) method, a printing method, a transfer method, or the like.

The electron injection layer and the electron transport layer are layers having any of a function of injecting electrons from the negative electrode, a function of transporting electrons, and a function of serving as a barrier to holes that may be injected from the positive electrode.

It is preferable that the layer in contact with the negative electrode be n-doped.

It is desirable for the electron-donating dopant that is introduced into the electron injection layer or the electron transport layer to be an electron-donating compound and to have a property of reducing an organic compound. Alkali metals such as lithium (Li); alkaline earth metals such as magnesium (Mg); transition metals including rare earth metals, and the like are suitably used.

Particularly, a metal having a work function of 4.2 eV or less may be suitably used, and specific examples thereof include lithium (Li), sodium (Na), potassium (K), beryllium (Be), magnesium (Mg), calcium (Ca), strontium (Sr), barium (Ba), yttrium (Y), cesium (Cs), lanthanum (La), samarium (Sm), gadolinium (Gd) and ytterbium (Yb).

These electron-donating dopants may be used singly, or may be used in combination of two or more kinds.

The amount of use of the electron-donating dopant may vary with the kind of the material, but the amount of use is preferably 0.1% by mass to 99% by mass, more preferably 0.5% by mass to 80% by mass, and even more preferably 1.0% by mass to 70% by mass, based on the electron transport layer material. If the amount of use is less than 0.1% by mass based on the electron transport layer material, the effects of the invention may be insufficient, and if the amount of use exceeds 99% by mass, the electron transport capability may be impaired.

Specific examples of the material of the electron injection layer and the electron transport layer include pyridines, pyrimidines, triazines, imidazoles, triazoles, oxazoles, oxadiazoles, fluorenones, anthraquinodimethanes, anthrones, diphenylquinones, thiopyran dioxides, carbodiimides, fluorenylidenemethanes, distyrylpyrazines, a fluorine-substituted aromatic compound, a heterocyclic tetracarboxylic acid anhydride of a naphthalene or a perylene, phthalocyanines, and derivatives thereof (may form fused rings with other rings); and various metal complexes such as a metal complex of an 8-quinolinol derivative, a metallophthalocyanine or a metal complex having a benzoxazole or a benzothiazole as a ligand.

The thickness of the electron injection layer and the electron transport layer is not particularly limited, but from the viewpoint of lowering the driving voltage, enhancing the light emission efficiency and enhancing durability, the thickness is preferably 1 nm to 500 nm, more preferably 5 nm to 200 nm, and even more preferably 10 nm to 100 nm.

The electron injection layer and the electron transport layer may have a single-layer structure composed of one kind or two or more kinds of the materials described above, or may have a multilayer structure formed of plural layers having an identical composition or different compositions.

The carrier mobility in the electron transport layer is generally from $10^{-7}$ $cm^2{\cdot}V^{-1}{\cdot}s^{-1}$ to $10^{-1}$ $cm^2{\cdot}V^{-1}{\cdot}s^{-1}$, and among others, in view of the light emission efficiency, the carrier mobility is preferably from $10^{-5}$ $cm^2{\cdot}V^{-1}{\cdot}s^{-1}$ to $10^{-1}$ $cm^2{\cdot}V^{-1}{\cdot}s^{-1}$, more preferably from $10^{-4}$ $cm^2{\cdot}V^{-1}{\cdot}s^{-1}$ to $10^{-1}$ $cm^2{\cdot}V^{-1}{\cdot}s^{-1}$, and even more preferably from $10^{-3}$ $cm^2{\cdot}V^{-1}{\cdot}s^{-1}$ to $10^{-1}$ $cm^2{\cdot}V^{-1}{\cdot}s^{-1}$.

According to the invention, it is preferable that the positive electrode-side intermediate layer, light emitting layer and negative electrode-side intermediate layer mentioned above are all organic layers, and it is more preferable that the main constituent materials of the organic layers be identical compounds. When identical compounds are used for the organic layers, the difference in the ionization potential and electron affinity between the positive electrode-side intermediate layer, the light emitting layer and the negative electrode-side intermediate layer is small, and the barriers at the interface between the positive electrode-side intermediate layer and the light emitting layer and at the interface between the light emitting layer and the negative electrode-side intermediate layer are diminished, so that accumulation of carriers at these interfaces may be suppressed. It is thought that as a result, an organic EL device without increase in the driving voltage may be obtained.

Even more preferably, the identical compounds are carbazole compounds. When carbazole compounds are used, the accumulation of carriers at the interface between the positive electrode-side intermediate layer and the light emitting layer, and at the interface between the light emitting layer and the negative electrode-side intermediate layer may be further suppressed.

<Electrode>

The organic EL device of the invention includes a pair of electrodes, namely, a positive electrode and a negative electrode. In view of the nature of the organic EL device, it is preferable that at least one of the positive electrode and the negative electrode be transparent. In general, the positive electrode has a function as an electrode that supplies holes to the organic compound layers, and the negative electrode has a function as an electrode that injects electrons to the organic compound layers.

The electrode is not particularly limited in terms of the shape, structure, size and the like, and may be appropriately selected among known electrode materials according to the use and purpose of the organic EL device.
Suitable examples of the material that constitutes the electrode include a metal, an alloy, a metal oxide, an electrically conductive compound, and mixtures thereof.

- Positive electrode -

Examples of the material that constitutes the positive electrode include electrically conductive metal oxides such as tin oxide doped with antimony or fluorine (ATO, FTO), tin oxide, zinc oxide, indium oxide, indium tin oxide (ITO), and indium zinc oxide (IZO); metals such as gold, silver, chromium and nickel; mixtures or laminates of these metals and electrically conductive metal oxides; inorganic electrically conductive materials such as copper iodide and copper sulfide; organic electrically conductive materials such as polyaniline, polythiophene and polypyrrole; and laminates of these with ITO. Among these, electrically conductive metal oxides are preferred, and from the viewpoint of productivity, high conductivity and transparency, ITO is particularly preferred.

- Negative electrode -

Examples of the material that constitutes the negative electrode include alkali metals (for example, Li, Na, K, and Cs), alkaline earth metals (for example, Mg and Ca), gold, silver, lead, aluminum, a sodium-potassium alloy, a lithium-aluminum alloy, a magnesium-silver alloy, indium, rare earth metals such as ytterbium. These may be used singly, but from the viewpoint of achieving a good balance between stability and electron injectability, two or more kinds may be suitably used in combination.
Among these, from the viewpoint of electron injectability, an alkali metal or an alkaline earth metal is preferred, and from the viewpoint of having excellent storage stability, a material primarily based on aluminum is preferred.
The material primarily based on aluminum refers to aluminum only, an alloy of aluminum with 0.01% by mass to 10% by mass of an alkali metal or an alkaline earth metal, or a mixture thereof (for example, a lithium-aluminum alloy, and a magnesium-aluminum alloy).
The method for forming the electrode is not particularly limited, and may be carried out according to a known method. Examples of the method include wet methods such as a printing method and a coating method; physical methods such as a vacuum deposition method, a sputtering method and an ion plating method; and chemical methods such as a CVD method and a plasma CVD method. Among these, the electrode may be formed on a substrate according to an appropriately selected method, in consideration of the compatibility with the material that constitutes the electrode. For example, when selecting ITO as a material of the positive electrode, the electrode may be formed according to a direct current or high frequency sputtering method, a vacuum deposition method, or an ion plating method. When selecting a metal or the like as the material of the negative electrode, one kind or two or more kinds of the materials may be used simultaneously or sequentially according to a vacuum deposition method.
In addition, in the case of carrying out patterning when an electrode is formed, the patterning may be carried out by chemical etching by photolithography or the like, or may be carried out by physical etching using a laser or the like. Furthermore, patterning may be carried out by vacuum deposition or sputtering after a mask is superimposed, or may be carried out according to a lift-off method or a printing method.

<Substrate>

The organic EL device of the invention is preferably installed on a substrate, and the organic EL device may be installed in the form such that the electrode and the substrate are in direct contact, or may be installed in the form of having an intermediate layer interposed therebetween.
The material of the substrate is not particularly limited, and may be appropriately selected according to the purpose. Examples include inorganic materials such as yttria-stabilized zirconia (YSZ), and glass (alkali-free glass, soda lime glass, or the like); polyesters such as such as polyethylene terephthalate, polybutylene phthalate, and polyethylene naphthalate; and organic materials such as polystyrene, polycarbonate, polyether sulfone, polyarylate, polyimide, polycycloolefin, a norbornene resin, and poly(chlorotrifluoroethylene).
The shape, structure, size and the like of the substrate are not particularly limited, and may be appropriately selected in accordance with the use, purpose and the like of the light emitting device. In general, the shape of the substrate is preferably a plate shape. The structure of the substrate may be a single layer structure or a laminate structure, and may be formed of a single member or may be formed of two or more members. The substrate may be transparent or may be opaque, and if transparent, the substrate may be colorless and transparent, or may be colored and transparent.
The substrate may be provided with a moisture penetration preventive layer (gas barrier layer) on the front surface or on the rear surface.

Examples of the material of the moisture penetration preventive layer (gas barrier layer) include inorganic substances such as silicon nitride and silicon oxide.

The moisture penetration preventive layer (gas barrier layer) may be formed by, for example, a high frequency sputtering method.

- Protective layer-

The entirety of the organic EL device may be protected by a protective layer.

The material contained in the protective layer is not particularly limited as long as the material has a function of preventing the factors that accelerate device deterioration, such as moisture or oxygen, from entering into the device, and may be appropriately selected according to the purpose. Examples of the material include metals such as indium (In), tin (Sn), lead (Pb), gold (Au), copper (Cu), silver (Ag), aluminum (Al), titanium (Ti) and nickel (Ni); metal oxides such as MgO, SiO, $SiO_2$, $Al_2O_3$, GeO, NiO, CaO, BaO, $Fe_2O_3$, $Y_2O_3$ and $TiO_2$; metal nitrides such as SiNx, and SiNxOy; metal fluorides such as $MgF_2$, LiF, $AlF_3$, and $CaF_2$; polyethylene, polypropylene, polymethyl methacrylate, polyimide, polyurea, polytetrafluoroethylene, polychlorotrifluoroethylene, polydichlorodifluoroethylene, a copolymer of chlorotrifluoroethylene and dichlorodifluoroethylene, a copolymer obtainable by copolymerizing a monomer mixture containing tetrafluoroethylene and at least one comonomer, a fluorine-containing copolymer having a cyclic structure in a copolymer main chain, a water-absorbing material having a water absorption ratio of 1% or greater, and a moisture-proof material having a water absorption ratio of 0.1% or less.

The method for forming the protective layer is not particularly limited, and may be appropriately selected according to the purpose. Examples of the method include a vacuum deposition method, a sputtering method, a reactive sputtering method, a molecular beam epitaxy (MBE) method, a cluster ion beam method, an ion plating method, a plasma polymerization method (high frequency excited ion plating method), a plasma CVD method, a laser CVD method, a thermal CVD method, a gas source CVD method, a coating method, a printing method and a transfer method.

- Sealing vessel -

The organic EL device of the invention may be such that the entire device is sealed using a sealing vessel. Furthermore, a moisture absorbent or an inert liquid may be inserted into the space between the sealing vessel and the organic EL device.

The moisture absorbent is not particularly limited, and may be appropriately selected according to the purpose. Examples of the moisture absorbent include barium oxide, sodium oxide, potassium oxide, calcium oxide, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieve, zeolite, and magnesium oxide.

The inert liquid is not particularly limited, and may be appropriately selected according to the purpose. Examples of the inert liquid include paraffins, liquid paraffins; fluorine-containing solvents such as perfluoroalkane, perfluoroamine, and perfluoro ether; chlorine-containing solvents, and silicone oils.

- Resin sealing layer -

It is preferable for the organic EL device of the invention that the deterioration of the device performance due to the oxygen or moisture present in the atmosphere be suppressed by sealing with a resin sealing layer.

The resin material of the resin sealing layer is not particularly limited, and may be appropriately selected according to the purpose. Examples of the resin material include an acrylic resin, an epoxy resin, a fluorine-containing resin, a silicone resin, a rubber-based resin, and an ester resin. Among these, an epoxy resin is particularly preferable in view of the moisture preventive function. Among the epoxy resins, a thermosetting epoxy resin or a photo-curable epoxy resin is preferred.

The method for producing the resin sealing layer is not particularly limited, and may be appropriately selected according to the purpose. Examples of the method include a method of coating a resin solution, a method of pressing or hot pressing a resin sheet, and a method of performing dry polymerization by deposition or sputtering.

- Sealing adhesive -

The sealing adhesive used in the invention has a function of preventing the infiltration of moisture or oxygen at the edges.

As the material of the sealing adhesive, the same materials as the materials used for the resin sealing layer may be used. Among these, in view of preventing moisture, an epoxy adhesive is preferred, and a photo-curable adhesive or a thermosetting adhesive is particularly preferred.

It is also preferable to add a filler to the sealing adhesive. Preferable examples of the filler include inorganic materials such as $SiO_2$, SiO (silicon oxide), SiON (silicon oxynitride), and SiN (silicon nitride). When the filler is added, the viscosity of the sealing adhesive increases, and the processing adaptability is enhanced, while moisture resistance is enhanced.

The sealing adhesive may contain a drying agent. Examples of the drying agent include barium oxide, calcium oxide and strontium oxide. The amount of addition of the drying agent is preferably 0.01% by mass to 20% by mass, and more preferably 0.05% by mass to 15% by mass, based on the sealing adhesive. If the amount of addition is less than 0.01% by mass, the effect of adding the drying agent may be decreased, and if the amount of addition exceeds 20% by mass, it may become difficult to uniformly disperse the drying agent in the sealing adhesive.

According to the invention, sealing may be achieved by applying an arbitrary amount of a sealing adhesive containing the drying agent using a dispenser or the like, subsequently superimposing a second substrate thereon, and curing the sealing adhesive.

FIG. 1 is a schematic diagram showing an example of the layer structure of the organic EL device of the invention. The organic EL device 10 has a layer structure including, on a glass substrate 1, a positive electrode 2 (for example, an ITO electrode), a hole injection layer 3, a hole transport layer 4, a light emitting layer 5, an electron transport layer 6, an electron injection layer 7, and a negative electrode 8 (for example, an Al-Li electrode) in this order. In addition, the positive electrode 2 (for example, an ITO electrode) and the negative electrode 8 (for example, an Al-Li electrode) are connected to each other through a power source.

- Driving -

The organic EL device of the invention may emit light when a direct current (may contain an alternating current component if necessary) voltage (usually, 2 volts to 15 volts), or a direct electric current is applied between the positive electrode and the negative electrode.

The organic EL device of the invention may be applied to an active matrix using a thin film transistor (TFT). As an active layer of the thin film transistor, amorphous silicon, high temperature polysilicon, low temperature polysilicon, microcrystalline silicon, oxide semiconductors, organic semiconductors, carbon nanotubes and the like may be applied.

For the organic EL device of the invention, those thin film transistors described in, for example, WO 2005/088726, JP-A No. 2006-165529, US Patent Application Publication No. 2008/0237598 A1 and the like may be applied.

The organic EL device of the invention is not particularly limited, and the light extraction efficiency may be increased by various known techniques. For example, the light extraction efficiency may be increased by processing the substrate surface shape (for example, forming a fine concavo-convex pattern), controlling the refractive indices of the substrate, the ITO layer and the organic layers, controlling the thickness of the substrate, the ITO layer and the organic layers, and the like, and thereby the external quantum efficiency may be increased.

The system for light extraction from the organic EL device of the invention may be a top emission system or a bottom emission system.

The organic EL device of the invention may have a resonator structure. For example, the resonator structure may include, on a transparent substrate, a multilayer film mirror formed of plural laminated films having different refractive indices, a transparent or a translucent electrode, a light emitting layer, and a metal electrode. The light generated in the light emitting layer is repeatedly reflected between the multilayer film mirror and the metal electrode as reflective plates, and thereby resonates.

In another preferred embodiment, the transparent or translucent electrode and the metal electrode on the transparent substrate respectively function as reflective plates, and the light generated in the light emitting layer is repeatedly reflected therebetween and thereby resonates.

In order to form a resonance structure, the optical path length which is determined from the effective refractive index of the two reflective plates, and the refractive indices and thicknesses of the respective layers between the reflective plates, is regulated so as to have an optimal value to obtain a desired resonance wavelength. The calculating expression used in the case of the first embodiment is described in JP-A No. 9-180883. The calculating expression used in the case of the second embodiment is described in JP-A No. 2004-127795.

- Applications -

Application of the organic EL device of the invention is not particularly limited, and may be appropriately selected according to the purpose; however, the organic EL device may be suitably used in display devices, displays, backlights, electrophotography, illumination light sources, recording light sources, exposure light sources, reading light sources, signs, signboards, interior decoration, optical communication, and the like.

Some known examples of the method of making the organic EL display into a full color type include a tricolor light emission method of disposing, on a substrate, organic EL devices respectively emitting lights corresponding to the

three primary colors (blue (B), green (G) and red (R)); a white color method of dividing the white light emitted by an organic EL device for white light emission, into three primary colors through a color filter; and a color conversion method of converting the blue light emitted by an organic EL device for blue light emission into red (R) and green (G) colors through fluorescent dye layers, as described in "Gekkan Display", September 2000, pp. 33-37. Furthermore, a planar light source of a desired luminescent color may be obtained by using a combination of plural organic EL devices of different luminescent colors obtainable by the methods described above. Examples of the light sources include a white luminescent light source combining light emitting devices of blue and yellow lights, and a white luminescent light source combining light emitting devices of blue, green and red lights.

EXAMPLES

Hereinafter, the invention will be described by way of Examples, but the invention is not intended to be limited to these Examples.

(Comparative Example 1)

- Production of organic EL device -

A film of ITO (indium tin oxide) having a thickness of 100 nm as a positive electrode was formed, on a glass substrate which measured 0.7 mm in thickness and 2.5 cm on each side, by a sputtering method.

Next, this ITO glass substrate was placed in a washing vessel and was washed by ultrasonication in 2-propanol, and the washed substrate was subjected to UV-ozone treatment for 30 minutes. On this glass substrate, respective layers as described below were deposited by a vacuum deposition method. The deposition rate used in the following Examples and Comparative Examples was 0.2 nm/second, unless particularly stated otherwise. The deposition rate was measured by using a crystal oscillator. Furthermore, the thickness of the following respective layers was measured by using a crystal oscillator.

First, a mixture of 2TNATA (4,4',4"-tris(N-(2-naphthyl)-N-phenylamino)triphenylamine) with F4TCNQ (p-doping material, the structure will be described later) in an amount of 1% by mass based on 2TNATA, was co-deposited on the positive electrode (ITO) as a hole injection layer to have a thickness of 120 nm.

Next, exemplary compound H-27 was deposited on the hole injection layer as a hole transport layer to have a thickness of 10 nm.

In this experiment, the hole injection layer and the hole transport layer serve as the positive electrode-side intermediate layers.

Next, a light emitting layer of the exemplary compound H-28 as a host material, which was doped with exemplary compound D-62 (a phosphorescent light emitting material) in an amount of 15% by mass based on H-28, was deposited on the hole transport layer to have a thickness of 30 nm.

Next, BAlq, which is an electron transporting material, was deposited on the light emitting layer as an electron transport layer to have a thickness of 10 nm.

Next, a mixture of BCP (an electron transporting material) and Li (n-doping material) at a mass ratio of 99:1 was deposited on the electron transport layer as an electron injection layer to have a thickness of 30 nm.

In this experiment, the electron injection layer and the electron transport layer serve as the negative electrode-side intermediate layers.

Next, a patterned mask (mask having a light emission area measuring 2 mm $\times$ 2 mm) was provided on the electron injection layer, and metallic aluminum was deposited as a negative electrode thereon to have a thickness of 100 nm.

The laminate thus produced was placed inside a glove box purged with argon gas, and was sealed using a stainless steel sealing can and an ultraviolet-curable type adhesive (trade name: XNR5516HV, manufactured by Nagase-Ciba, Ltd.). Thereby, an organic EL device of Comparative Example 1 was produced.

(Comparative Examples 2 and 3 and Examples 1 to 6)

Organic EL devices of Comparative Examples 2 and 3 and Examples 1 to 6 were produced in the same manner as in the production of the organic EL device of Comparative Example 1, except that the deposition materials of Comparative Example 1 were changed as indicated in Table 1.

The ionization potential and electron affinity of the respective layers indicated in Table 1 are the values of the main constituent materials of the respective layers. The ionization potentials of exemplary compound H-27, exemplary compound H-30 and exemplary compound H-29, which were used as supplementary constituent materials of the light emitting layer are H27: 5.6 eV, H-30: 5.6 eV, and H-29: 5.7 eV, respectively. Exemplary compound H-31 is an electrically

inert material having an energy gap of 4.0 eV or greater and an ionization potential of 6.1 eV or greater.

Among the deposition materials used in Comparative Examples 1 to 3 and Examples 1 to 6, and the deposition materials used in Comparative Examples 4 and 5 and Examples 7 and 8, H-27, H-28, H-29, H-30, H-31, D-13, D-27 and D-62 are exemplary compounds as described above. The chemical names of other materials are as shown below.

F4TCNQ: Tetrafluorotetracyanoquinodimethane
BAlq: Aluminum(III) bis(2-methyl-8-quinolinato) 4-phenylphenolate
BCP: Bathocuproin

The organic EL devices of blue light emission thus obtained were used to perform an evaluation as shown below. The results are summarized and presented in Table 2.

In regard to the driving voltage and the external quantum efficiency, the values at a current density of 2.5 $mA/cm^2$ were measured, using a source measure unit (trade name: Model 2400, manufactured by Keithley Instruments, Inc.) and an luminance meter (trade name: SR-3, manufactured by Topcon Corp.), respectively.

In regard to the driving durability, constant current driving was carried out at an initial luminance of 2000 $cd/m^2$, and the time at which the luminance value was reduced to one-half of the initial value, was measured. The relative values calculated on the basis of the luminance half-life of Comparative Example 1 (which was taken as 100) are presented in Table 2.

The measurement of the ionization potentials of the respective materials described in Table 1 was carried out using a deposited film of each material having a thickness of 50 nm on a glass substrate, and using AC-2 manufactured by Riken Keiki Co., Ltd. The electron affinity of each layer was obtained by determining the energy gap from the long wavelength edge of the optical absorbance spectrum of the deposited film, and calculating based on the formula: (electron affinity) = (ionization potential) - (energy gap). The electron mobility and the hole mobility of the respective light emitting layers were obtained by producing a single-layer film (film thickness: about 2 μm) of each light emitting layer attached with electrodes, and measuring by a Time-of-Flight method.

Table 1

| | Hole injection layer | Hole transport layer | Light emitting layer | Electron transport layer | Electron injection layer |
|---|---|---|---|---|---|
| Comparative Example 1 | 2TNATA+1%F4TCNQ | H-27 | H-28 +15%D-62 | BAlq | BCP+Li |
| | Ip=5.2 eV | Ip=5.6 eV<br>Ea=2.3eV | Ip-5.9 eV<br>Ea=2.4 eV<br>μh/μe=16 | Ip=5.9 eV<br>Ea=2.9eV | Ea=3.2 eV |
| Comparative Example 2 | 2TNATA+1%F4TCNQ | H-27 | H-28+15%D-62 +2%H-27 | BAlq | BCP+Li |
| | Ip=5.2 eV | Ip=5.6 eV<br>Ea=2.3 eV | Ip=5.9 eV<br>Ea=2.4 eV<br>μh/μe=1.4 | Ip=5.9 eV<br>Ea=2.9eV | Ea=3.2 eV |
| Comparative Example 3 | H-28+10%$MoO_3$ | H-28 | H-28 +15%D-62 | H-28 | H-28+Cs |
| | Ip=5.9 eV | Ip=5.9 eV<br>Ea=2.4eV | Ip=5.9 eV<br>Ea=2.4 eV<br>μh/μe=16 | Ip=5.9 eV<br>Ea=2.4eV | Ea=2.4 eV |
| Example 1 | H-28 + 10%$MoO_3$ | H-28 | H-28+15%D-62 +2%H-27 | H-28 | H-28+Cs |
| | Ip=5.9 eV | Ip=5.9 eV<br>Ea=2.4eV | Ip-5.9eV<br>Ea=2.4 eV<br>μh/μe=1.4 | Ip=5.9 eV<br>Ea=2.4 eV | Ea=2.4 eV |
| Example 2 | H-28+1 0%$MoO_3$ | H-28 | H-28+15%D-62 +8%H-27 | H-28 | H-28+Cs |
| | Ip=5.9 eV | Ip=5.9 eV<br>Ea=2.4eV | Ip=5.9 eV<br>Ea=2.4 eV<br>μh/μe=1.4 | Ip=5.9 eV<br>Ea=2.4eV | Ea=2.4 eV |

(continued)

| | Hole injection layer | Hole transport layer | Light emitting layer | Electron transport layer | Electron injection layer |
|---|---|---|---|---|---|
| Example 3 | H-28+10%$MoO_3$ | H-28 | H-28+15%D-62 +2%H-30 | H-28 | H-28+Cs |
| | Ip=5.9 eV | Ip=5.9 eV Ea=2.4eV | Ip=5.9 eV Ea=2.4 eV $\mu h/\mu e$=1.4 | Ip=5.9 eV Ea=2.4eV | Ea=2.4 eV |
| Example 4 | H-28+10%$MoO_3$ | H-28 | H-28+15%D-62 +2%H-29 | H-28 | H-28+Cs |
| | Ip=5.9 eV | Ip=5.9 eV Ea=2.4eV | Ip=5.9 eV Ea=2.4 eV $\mu h/\mu e$=1.4 | Ip=5.9 eV Ea=2.4eV | Ea=2.4 eV |
| Example 5 | H-28+10%$MoO_3$ | H-28 | H-28+15%D-62 +20%H-31 | H-28 | H-28+Cs |
| | Ip=5.9 eV | Ip=5.9 eV Ea=2.4eV | Ip=5.9 eV Ea=2.4 eV $\mu h/\mu e$=2.1 | Ip=5.9 eV Ea=2.4eV | Ea=2.4 eV |
| Exmaple 6 | mCP+10%$MoO_3$ | mCP | H-28+ 15%D-62 +2%H-27 | mCP | mCP+Cs |
| | Ip=5.9 eV | Ip=5.9 eV Ea=2.4eV | Ip=5.9 eV Ea=2.4 eV $\mu h/\mu e$=1.4 | Ip=5.9 eV Ea=2.4eV | Ea=2.4 eV |

Table 2

| | External quantum efficiency (%) | Driving voltage (V) | Driving durability |
|---|---|---|---|
| Comparative Example 1 | 8.0 | 7.0 | 100 |
| Comparative Example 2 | 10.4 | 7.3 | 120 |
| Comparative Example 3 | 6.4 | 4.5 | 90 |
| Example 1 | 14.4 | 4.8 | 140 |
| Example 2 | 14.1 | 5.0 | 135 |
| Example 3 | 14.4 | 4.8 | 140 |
| Example 4 | 13.7 | 4.7 | 135 |
| Example 5 | 14.2 | 5.0 | 130 |
| Example 6 | 14.0 | 5.1 | 135 |

The following facts were found from the results of Table 2. Examples 1 to 4 and 6, in which the ionization potential satisfied the expression (1), the electron affinity satisfied the expression (2), the hole mobility and the electron mobility satisfied the expression (3), and the light emitting layer contained a constituent material exhibiting an ionization potential lower than that of the main constituent material of the light emitting layer in an amount in the range of 0.5 to 20% by mass relative to the total mass of the light emitting layer, had a high external quantum efficiency, a low driving voltage and satisfactory driving durability. Particularly, Examples 1 to 5, which used a carbazole compound as a compound present in common in the hole injection layer, the hole transport layer, the light emitting layer, the electron transport layer and the electron injection layer, were excellent in these properties.

On the contrary, Comparative Examples 1 and 2, in which the ionization potential did not satisfy the expression

(1), and the electron affinity did not satisfy the expression (2), all had low external quantum efficiencies, high driving voltages, and poor driving durability. Comparative Example 3, in which the ionization potential satisfied the expression (1), and the electron affinity satisfied the expression (2), but the hole mobility and the electron mobility did not satisfy the expression (3), had poor external quantum efficiency and driving durability, and was particularly inferior in the external quantum efficiency.

(Comparative Example 4 and Example 7)

Organic EL devices of green light emission of Comparative Example 4 and Example 7 were produced in the same manner as in Comparative Example 1, except that the deposition materials of Comparative Example 1 were changed to the deposition materials indicated for Comparative Example 4 and Example 7 in Table 3. The same evaluations as performed in Comparative Example 1 were carried out, and the results are presented in Table 4. However, the driving durability was indicated as a relative value calculated based on the luminance half-life of Comparative Example 4 (which was taken as 100).

(Comparative Example 5 and Example 8)

Organic EL devices of red light emission of Comparative Example 5 and Example 8 were produced in the same manner as in Comparative Example 1, except that the deposition materials of Comparative Example 1 were changed to the deposition materials indicated for Comparative Example 5 and Example 8 in Table 3. The same evaluations as performed in Comparative Example 1 were carried out, and the results are presented in Table 4. However, the driving durability was indicated as a relative value calculated based on the luminance half-life of Comparative Example 5 (which was taken as 100).

Table 3

| | Hole injection layer | Hole transport layer | Light emitting layer | Electron transport layer | Electron injection layer |
|---|---|---|---|---|---|
| Comparative Example 4 | H-28 +10%$MoO_3$ | H-28 | H-28 +15%D-27 | H-28 | H-28+Cs |
| | Ip=5.9 eV | Ip=5.9 eV<br>Ea=2.4 eV | Ip=5.9 eV<br>Ea=2.4 eV<br>$\mu h/\mu e$=14 | Ip=5.9 eV<br>Ea=2.4 eV | Ea=2.4 eV |
| Example 7 | H-28 +10%$MoO_3$ | H-28 | H-28+15%D-27 +2%H-27 | H-28 | H-28+Cs |
| | Ip=5.9 eV | Ip=5.9 eV<br>Ea=2.4 eV | Ip=5.9 eV<br>Ea=2.4 eV<br>$\mu h/\mu e$=1.2 | Ip=5.9 eV<br>Ea=2.4 eV | Ea=2.4 eV |
| Comparative Example 5 | H-28 +10%$MoO_3$ | H-28 | H-28 +10%D-13 | H-28 | H-28+Cs |
| | Ip=5.9 eV | Ip=5.9 eV<br>Ea=2.4 eV | Ip=5.9 eV<br>Ea=2.4 eV<br>$\mu h/\mu e$=25 | Ip=5.9 eV<br>Ea=2.4 eV | Ea=2.4 eV |
| Example 8 | H-28 +10%$MoO_3$ | H-28 | H-28+10%D-13 +2%H-27 | H-28 | H-28+Cs |
| | Ip=5.9 eV | Ip=5.9 eV<br>Ea=2.4 eV | Ip=5.9 eV<br>Ea=2.4 eV<br>$\mu h/\mu e$=2.2 | Ip=5.9 eV<br>Ea=2.4 eV | Ea=2.4 eV |

Table 4

| | External quantum efficiency (%) | Driving voltage (V) | Driving durability |
|---|---|---|---|
| Comparative Example 4 | 10.5 | 4.0 | 100 |
| Example 7 | 17.8 | 4.3 | 150 |
| Comparative Example 5 | 11.0 | 4.4 | 100 |
| Exmaple 8 | 17.3 | 4.7 | 140 |

The following facts were found from the results of Table 4. Examples 7 and 8, which were organic EL display devices of green and red colors making use of the invention, all had high external quantum efficiencies and satisfactory driving durability. On the contrary, Comparative Examples 4 and 5, which did not make use of the invention, all had low external quantum efficiencies and poor driving durability.

When these results are considered together with the results of Table 2, it may be seen that the invention has high external quantum efficiency, a low driving voltage and satisfactory driving durability.

## Claims

1. An organic electroluminescent device comprising:

   a pair of electrodes composed of a positive electrode and a negative electrode;
   a light emitting layer interposed between the electrodes;
   at least one positive electrode-side intermediate layer interposed between the positive electrode and the light emitting layer; and
   at least one negative electrode-side intermediate layer interposed between the negative electrode and the light emitting layer
   wherein the following expressions (1) and (2) are satisfied

   $$Ip(EML) - 0.1\ eV < Ip(1i) < Ip(EML) + 0.1\ eV \qquad (1)$$

   $$Ea(EML) - 0.1\ eV < Ea(2i) < Ea(EML) + 0.1\ eV \qquad (2)$$

   wherein Ip(EML) represents the ionization potential of the main constituent material of the light emitting layer, Ea(EML) represents the electron affinity of the main constituent material of the light emitting layer, Ip(1i) represents the ionization potential of the main constituent material of the at least one positive electrode-side intermediate layer, and Ea(2i) represents the electron affinity of the main constituent material of the at least one negative electrode-side intermediate layer;
   the following expression (3) is satisfied

   $$0.1 \leq \mu h/\mu e \leq 10 \qquad (3)$$

   wherein $\mu h$ and $\mu e$ represent the hole mobility and the electron mobility of the light emitting layer at an electric field of $10^6$ V/cm, respectively; and
   the light emitting layer contains a compound having an ionization potential lower than the ionization potential Ip(EML) of the main constituent material of the light emitting layer in an amount of from 0.5% by mass to 20% by mass relative to the total mass of the light emitting layer, or the light emitting layer contains an electrically inert material instead of a compound having an ionization potential lower than the ionization potential Ip(EML) of the main constituent material.

2. The organic electroluminescent device of claim 1, wherein a layer in contact with the positive electrode is p-doped.

3. The organic electroluminescent device of claim 1 or 2, wherein the at least one positive electrode-side intermediate layer includes a hole injection layer.

4. The organic electroluminescent device of any one of claims 1 to 3, wherein a layer in contact with the negative electrode is n-doped.

5. The organic electroluminescent device of any one of claims 1 to 4, wherein the at least one negative electrode-side intermediate layer includes an electron injection layer.

6. The organic electroluminescent device of any one of claims 1 to 5, wherein the at least one positive electrode-side intermediate layer, the light emitting layer and the at least one negative electrode-side intermediate layer are all organic layers.

7. The organic electroluminescent device of claim 6, wherein the main constituent materials of the organic layers are identical compounds.

8. The organic electroluminescent device of claim 6 or 7, wherein the main constituent materials of the organic layers are all carbazole compounds.

**Patentansprüche**

1. Eine organische elektrolumineszente Vorrichtung aufweisend:

ein Elektrodenpaar bestehend aus einer positiven Elektrode und einer negativen Elektrode;
eine zwischen die Elektroden eingefügte lichtemittierende Schicht;
wenigstens eine auf der Seite der positiven Elektrode befindliche Zwischenschicht, die zwischen der positiven Elektrode und der lichtemittierenden Schicht eingefügt ist; und
wenigstens eine auf der Seite der negativen Elektrode befindliche Zwischenschicht, die zwischen der negativen Elektrode und der lichtemittierenden Schicht eingefügt ist
wobei die folgenden Bedingungen (1) und (2) erfüllt sind

$$Ip(EML) - 0{,}1\ eV < Ip(1i) < Ip(EML) + 0{,}1\ eV \qquad (1)$$

$$Ea(EML) - 0{,}1\ eV < Ea(2i) < Ea(EML) + 0{,}1\ eV \qquad (2)$$

wobei Ip(EML) das Ionisationspotential des Hauptbestandteils der lichtemittierenden Schicht darstellt, Ea(EML) die Elektronenaffinität des Hauptbestandteils der lichtemittierenden Schicht darstellt, Ip(1i) das Ionisationspotential des Hauptbestandteils der wenigstens einen auf der Seite der positiven Elektrode befindlichen Zwischenschicht darstellt, und Ea(2i) die Elektronenaffinität des Hauptbestandteils der wenigstens einen auf der Seite der negativen Elektrode befindlichen Zwischenschicht darstellt;
wobei die folgende Bedingung (3) ist erfüllt ist

$$0{,}1 \leq \mu h/\mu e \leq 10 \qquad (3)$$

wobei $\mu h$ und $\mu e$ die Löchermobilität beziehungsweise die Elektronenmobilität der lichtemittierenden Schicht bei einem elektrischen Feld von $10^6$ V/cm darstellen; und
die lichtemittierende Schicht eine Verbindung enthält, die ein niedrigeres Ionisationspotential als das Ionisationspotential Ip(EML) des Hauptbestandteils der lichtemittierenden Schicht hat, mit einem Massenanteil von 0,5% bis 20% relativ zur gesamten Masse der lichtemittierenden Schicht, oder die lichtemittierende Schicht ein elektrisch inertes Material anstatt einer Verbindung enthält, die ein niedrigeres Ionisationspotential als das Ionisationspotential Ip(EML) des Hauptbestandteils hat.

2. Die organische elektrolumineszente Vorrichtung gemäß Anspruch 1, wobei eine Schicht in Kontakt mit der positiven Elektrode p-dotiert ist.

3. Die organische elektrolumineszente Vorrichtung gemäß Anspruch 1 oder 2, wobei die wenigstens eine auf der Seite

der positiven Elektrode befindliche Zwischenschicht eine Löcherinjektionsschicht enthält.

**4.** Die organische elektrolumineszente Vorrichtung gemäß einem der Ansprüche 1 bis 3, wobei eine Schicht in Kontakt mit der negativen Elektrode n-dotiert ist.

**5.** Die organische elektrolumineszente Vorrichtung gemäß einem der Ansprüche 1 bis 4, wobei die wenigstens eine auf der Seite der negativen Elektrode befindliche Zwischenschicht eine Elektroneninjektionsschicht enthält.

**6.** Die organische elektrolumineszente Vorrichtung gemäß einem der Ansprüche 1 bis 5, wobei die wenigstens eine auf der Seite der positiven Elektrode befindliche Zwischenschicht, die lichtemittierende Schicht und die wenigstens eine auf der Seite der negativen Elektrode befindliche Zwischenschicht alle organische Schichten sind.

**7.** Die organische elektrolumineszente Vorrichtung gemäß Anspruch 6, wobei die Hauptbestandteile der organischen Schichten identische Verbindungen sind.

**8.** Die organische elektrolumineszente Vorrichtung gemäß Anspruch 6 oder 7, wobei die Hauptbestandteile der organischen Schichten alle Carbazolverbindungen sind.

## Revendications

**1.** Un dispositif électroluminescent organique comprenant :

une paire d'électrodes composée d'une électrode positive et d'une électrode négative ;
une couche émettrice de lumière interposée entre les électrodes ;
au moins une couche intermédiaire côté électrode positive, interposée entre l'électrode positive et la couche émettrice de lumière ; et
au moins une couche intermédiaire côté électrode négative, interposée entre l'électrode négative et la couche émettrice de lumière,
les expressions suivantes (1) et (2) étant satisfaites :

$$Ip(EML) - 0{,}1\ eV < Ip(1i) < Ip(EML) + 0{,}1\ eV \qquad (1)$$

$$Ea(EML) - 0{,}1\ eV < Ea(2i) < Ea(EML) + 0.1\ eV \qquad (2)$$

Ip(EML) représentant le potentiel d'ionisation du matériau constituant principal de la couche émettrice de lumière, Ea(EML) représentant l'affinité électronique du matériau constituant principal de la couche émettrice de lumière, Ip(1i) représente le potentiel d'ionisation du matériau constituant principal de ladite au moins une couche intermédiaire côté électrode positive, et Ea(2i) représente l'affinité électronique du matériau constituant principal de ladite au moins une couche intermédiaire côté électrode négative ;
l'expression suivante (3) étant satisfaite :

$$0{,}1 \leq \mu h/\mu e \leq 10 \qquad (3)$$

$\mu$h et $\mu$e représentant respectivement la mobilité des trous et la mobilité des électrons de la couche émettrice de lumière à un champ électrique de $10^6$ V/cm ; et
la couche émettrice de lumière contient un composé ayant un potentiel d'ionisation inférieur au potentiel d'ionisation Ip(EML) du matériau constituant principal de la couche émettrice de lumière en une quantité allant de 0,5% en masse à 20% en masse par rapport à la masse totale de la couche émettrice de lumière, ou la couche émettrice de lumière contient un matériau inerte électriquement au lieu d'un composé ayant un potentiel d'ionisation inférieur au potentiel d'ionisation Ip(EML) du matériau constituant principal.

**2.** Le dispositif électroluminescent organique selon la revendication 1, dans lequel une couche en contact avec l'électrode positive est dopée en p.

3. Le dispositif électroluminescent organique selon la revendication 1 ou la revendication 2, dans lequel ladite au moins une couche intermédiaire côté électrode positive comprend une couche d'injection à trous.

4. Le dispositif électroluminescent organique selon l'une quelconque des revendications 1 à 3, dans lequel une couche en contact avec l'électrode négative est dopée en n.

5. Le dispositif électroluminescent organique selon l'une quelconque des revendications 1 à 4, dans lequel ladite au moins une couche intermédiaire côté électrode négative comprend une couche d'injection électronique.

6. Le dispositif électroluminescent organique selon l'une quelconque des revendications 1 à 5, dans lequel ladite au moins une couche intermédiaire côté électrode positive, la couche émettrice de lumière et ladite au moins une couche intermédiaire côté électrode négative sont toutes des couches organiques.

7. Le dispositif électroluminescent organique selon la revendication 6, dans lequel les principaux matériaux constitutifs des couches organiques sont des composés identiques.

8. Le dispositif électroluminescent organique selon la revendication 6 ou la revendication 7, dans lequel les principaux matériaux constitutifs des couches organiques sont tous des composés de carbazole.

FIG.1

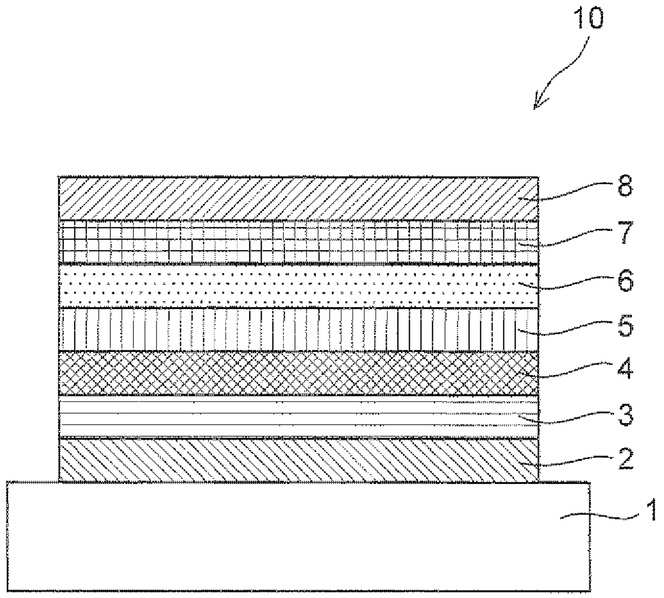

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2008102644 A
- JP 2005294250 A
- JP 2006270091 A
- JP 2008227462 A
- JP 2007043130 A
- US 20060273714 A1
- US 6303238 B1
- US 6097147 A
- WO 0057676 A
- WO 0070655 A
- WO 0108230 A
- WO 0139234 A2
- WO 0141512 A1
- WO 0202714 A2
- WO 0215645 A1
- WO 0244189 A1
- JP 2001247859 A
- JP 2000033561 A
- JP 2002117978 A
- JP 2002225352 A
- JP 2002235076 A
- JP 2001239281 A
- JP 2002170684 A
- EP 1211257 A
- JP 2002226495 A
- JP 2002234894 A
- JP 2001298470 A
- JP 2002173674 A
- JP 2002203678 A
- JP 2002203679 A
- JP 2004357791 A
- JP 2006256999 A
- JP 2005075341 A
- JP 2009032976 A
- JP 2004214179 A
- JP 2004221062 A
- JP 2004221065 A
- JP 2004221068 A
- JP 2004327313 A
- JP 2008126130 A
- JP 2004515506 A
- WO 2005088726 A
- JP 2006165529 A
- US 20080237598 A1
- JP 9180883 A
- JP 2004127795 A


### Non-patent literature cited in the description


- *Adv. Mater.,* 2009, vol. 21, 1-4
- **MATSUSHIMA TOSHINORI et al.** Enhancing power conversion efficiencies and operation stability of organic light-emitting diodes by increasing carrier injection efficiencies at anode/organic and organic/organic heterojunction interfaces. *J. Appl. Phys.,* 2008, vol. 104, 34507-1, 34507-4
- **PARSHIN et al.** *Proc.of SPIE,* 2006, vol. 6192, 61922A-1, 61922A-8
- **LEE et al.** *Mol. Cryst. Liq. Cryst.,* 2003, vol. 405, 67-73
- **G. WILKINSON et al.** Comprehensive Coordination Chemistry. Pergamon Press, 1987
- **H. YERSIN.** Photochemistry and Photophysics of Coordination Compounds. Springer-Verlag GmbH, 1987
- **YAMAMOTO AKIO.** Organometallic Chemistry - Fundamentals and Applications. Shokabo Publishing Co., Ltd, 1982
- *Gekkan Display,* September 2000, 33-37